# EUROPEAN PATENT SPECIFICATION

(11) **EP 3 069 446 B1**
(45) Date of publication and mention of the grant of the patent: **04.01.2023**
(21) Application number: 14861506.5
(22) Date of filing: 11.11.2014
(51) Int. Cl.: H03K 17/10, H04B 1/44, H03K 17/16, H03K 17/687, H01L 21/8234

(54) **CIRCUITS AND METHODS FOR IMPROVED QUALITY FACTOR IN A STACK OF TRANSISTORS**
SCHALTUNGEN UND VERFAHREN FÜR VERBESSERTEN QUALITÄTSFAKTOR IN EINEM STAPEL VON TRANSISTOREN
CIRCUITS ET PROCÉDÉS POUR UN FACTEUR DE QUALITÉ AMÉLIORÉ DANS UNE PILE DE TRANSISTORS

(30) Priority: 13.11.2013 US 201361903900 P; 10.11.2014 US 201414536814
(43) Date of publication of application: 21.09.2016
(73) Proprietor: Skyworks Solutions, Inc., Woburn, MA 01801 (US)
(72) Inventor: BLIN, Guillaume Alexandre, Carlisle, Massachusetts 01741 (US)
(74) Representative: Lloyd, Patrick Alexander Desmond
(86) International application number: PCT/US2014/065070
(87) International publication number: WO 2015/073453

(56) References cited:
- JP-A- 2010 114 837
- JP-A- 2012 104 615
- US-A1- 2004 141 470
- US-A1- 2004 251 952
- US-A1- 2005 014 473
- US-A1- 2010 069 020
- US-A1- 2011 025 403
- US-A1- 2011 092 179
- US-A1- 2011 221 519
- US-A1- 2011 260 773
- US-A1- 2012 081 262
- US-A1- 2013 278 317
- US-B1- 8 461 903
- MINSIK AHN ET AL: "Ultra low loss and high linearity SPMT antenna switch using SOI CMOS process", MICROWAVE CONFERENCE (EUMC), 2010 EUROPEAN, IEEE, PISCATAWAY, NJ, USA, 28 September 2010 (2010-09-28), pages 652-655, XP031785727, ISBN: 978-1-4244-7232-1

## Description

### BACKGROUND

The present disclosure generally relates to circuits and methods for improved quality factor in a stack of transistors in radio-frequency (RF) applications.

In some radio-frequency (RF) applications, a plurality of switching elements (e.g., field-effect transistors (FETs)) are commonly arranged in a stack configuration to facilitate appropriate handling of power. For example, a higher stack height can be utilized to allow an RF switch to withstand higher power.

When such FETs are in an OFF state, they can be thought of as acting as a shunt "high" impedance respect to ground. Such an OFF stack will typically present a capacitance Coff and an impedance Roff that can create mismatch loss (e.g., due to Coff) and/or dissipative loss (e.g., due to Roff). In a situation where a high voltage is applied to the OFF stack, the dissipative loss due to Roff can become significant (e.g., similar to a tuning or resonant circuit). Such an effect can also reduce the quality factor (Q), and thus usefulness, of a corresponding resonant circuit.

In US 2011/0260773 A1, there are described embodiments of a stacked FET switch having a plurality of FET devices coupled in series to form an FET device stack. To prevent the FET device stack from being turned on during large signal conditions, one or more decoupling paths are provided and are configured to pass the time-variant input signal during the open state of the FET device stack.

In US 2004/0251952 A1, the first terminals of a plurality of resistor elements are connected to the intermediate connection points of a plurality of FETs connected in series, and a voltage, having a phase opposite to that of the voltage applied to the gate terminals of the plurality of FETs, is applied to the second terminals of the plurality of resistor elements.

In US 8,461,903 B1, there is provided a FET switch topology that, it is reported, greatly reduces the off state loading experienced by the gate biasing resistors in a stacked FET structure. The FET switch topology evenly distributes the voltage across the FET switch topology which reduces the voltage across the gate biasing resistors when the stacked FET structure is in an off state. Because the off state loading is reduced, there is a corresponding reduction of the current through bias resistors, which permits a reduction in the size of the bias resistors. This permits a substantial reduction in the area attributed to the bias resistors in an integrated solution.

In US 2013/0278317 A1, switchable capacitive elements are disclosed, along with programmable capacitor arrays (PCAs). One embodiment of the switchable capacitive element includes a field effect transistor (FET) device stack, a first capacitor, and a second capacitor. The FET device stack is operable in an open state and in a closed state and has a plurality of FET devices coupled in series to form the FET device stack. The first capacitor and the second capacitor are both coupled in series with the FET device stack. However, the first capacitor is coupled to a first end of the FET device stack while the second capacitor is coupled to a second end opposite the first end of the FET device stack.

In US 2011/0025403 A1, a switch is implemented with a set of transistors, a set of resistors, and an additional resistor. The set of transistors is coupled in a stacked configuration, receives an input signal, and provides an output signal. The set of resistors is coupled to the gates of the set of transistors. The additional resistor is coupled to the set of resistors and receives a control signal for the set of transistors. The resistors reduce signal loss through parasitic capacitances of the transistors when they are turned on. The resistors also help split the signal swing of the input signal approximately evenly across the transistors when they are turned off, which may improve reliability of the transistors.

In US 2012/0081262 A1, a switch circuit with a unit capable of improving a margin voltage without using a negative bias generation circuit is provided. A switch comprising an N-type MOSFET is used for a switch passing a signal to an antenna and a switch comprising a P-type MOSFET is used for a shunt switch grounding a signal. A common control signal is input to the gate terminal of the MOSFET constituting each switch. The inverted signal of this control signal is coupled to a ground terminal of the switch, and thus the potential of the gate terminal of each MOSFET can be set to the ground voltage.

### SUMMARY

In accordance with a first aspect of the invention there is provided a switching device comprising: a first terminal and a second terminal; a plurality of field-effect transistors, FETs, implemented in a stack configuration between the first terminal and the second terminal, each FET having a source, a drain and a gate, the FETs configured to be in an ON state or an OFF state to respectively allow or inhibit passage of a radio-frequency, RF, signal between the first and second terminals; and a bias circuit having a bias input node and a gate resistance network that couples the bias input node to the gate of each FET, the gate resistance network including a plurality of first nodes and one or more second nodes, each first node of the plurality of first nodes connected to more than one of the gates through respective first resistive paths, each second node of the one or more second nodes connected to one or more first nodes of the plurality of first nodes through one or more respective second resistive paths, the gate of each FET being coupled to the bias input node through a first node of the plurality of first nodes and a second node of the one or more second nodes.

In some embodiments, the FET can be implemented as a silicon-on-insulator (SOI) device. The FET can be implemented as a finger configuration device such that the gate includes a number of rectangular shaped gate fingers, with each gate finger implemented between a rectangular shaped source finger of the source contact and a rectangular shaped drain finger of the drain contact.

In some embodiments, the first terminal can be an input terminal and the second terminal can be an output terminal for the RF signal.

In some embodiments, the bias input node can be connected to one second node through a common resistance. The one or more second nodes can be connected to a plurality of first nodes through their respective inter-node resistances. Each of the plurality of second nodes can be connected to a plurality of gates through their respective gate resistances.

In some embodiments, each resistive path between the corresponding first node and the corresponding gate can include a gate resistor. Each gate resistor can be configured to reduce loss of the RF signal to ground through parasitic capacitance associated with the gate resistor. Each gate resistor can have a reduced value of DC resistance, with the reduced DC resistance resulting in a higher effective resistance for the frequency of the RF signal. The higher effective resistance of the gate resistors can result in an increase in an overall resistance (R_{OFF}) of the switching device for the RF signal when the FETs are in the OFF state. The increased R_{OFF} can result in a higher Q factor performance of the switching device.

In some embodiments, each resistive path between the corresponding first node and the corresponding second node can include an additional resistor. Each of the additional resistors can be configured to reduce loss of the RF signal to the bias input node, and to reduce loss of the RF signal between the first and second terminals.

In some embodiments, the switching device can further include a source/drain bias circuit having a source/drain bias input node and a distribution network that couples the source/drain bias input node to the source/drain of each FET. The distribution network can include a plurality of first nodes, with each first node being connected to one or more of the sources/drains through one or more respective resistive paths. The distribution network can further include one or more second nodes, with each second node being connected to one or more of the first nodes through one or more respective resistive paths. At least some of the resistive paths associated with the first nodes and the second nodes can have resistance values selected to reduce loss of the RF signal when the FETs are in the OFF state.

In some embodiments, the switching device can further include a body bias circuit having a body bias input node and a distribution network that couples the body bias input node to the body of each FET. The distribution network can include a plurality of first nodes, with each first node being connected to one or more of the bodies through one or more respective resistive paths. The distribution network can further include one or more second nodes, with each second node being connected to one or more of the first nodes through one or more respective resistive paths. At least some of the resistive paths associated with the first nodes and the second nodes can have resistance values selected to reduce loss of the RF signal when the FETs are in the OFF state.

In some embodiments, the stack configuration can include the plurality of FETs being connected in series. In some embodiments, the plurality of FETs can form a substantially continuous chain of FETs.

In some teachings, the present disclosure relates to a semiconductor die having a semiconductor substrate and the above-described switching device implemented on the semiconductor substrate.

In accordance with a further aspect of the invention, there is provided a method for fabricating a radio-frequency (RF) switching device. The method includes providing a semiconductor substrate; forming a switching circuit on the semiconductor substrate, the switching circuit including a plurality of field-effect transistors, FETs, implemented in a stack configuration, each FET having a source, a drain and a gate, the FETs configured to be in an ON state or an OFF state to respectively allow or inhibit passage of an RF signal through the stack; and forming a bias circuit on the semiconductor substrate, the bias circuit having a bias input node and a gate resistance network that couples the bias input node to the gate of each FET, the gate resistance network including a plurality of first nodes and one or more second nodes, each first node of the plurality of first nodes connected to one or more of the gates through one or more respective first resistive paths, each second node of the one or more second nodes connected to one or more first nodes of the plurality of first nodes through one or more respective second resistive paths, the gate of each FET being coupled to the bias input node through a first node of the plurality of first nodes and a second node of the one or more second nodes.

In accordance with a further aspect of the invention, there is provided a radio-frequency (RF) switching module having a packaging substrate configured to receive a plurality of components, and a die mounted on the packaging substrate. The die includes a switching device as described above.

In accordance with a further aspect of the invention, there is provided a wireless device having a transmitter and a power amplifier in communication with the transmitter. The power amplifier is configured to amplify a radio-frequency (RF) signal generated by the transmitter. The wireless device further includes an antenna configured to transmit the amplified RF signal, and a switching device as described above, the switching device configured to route the amplified RF signal from the power amplifier to the antenna.

For purposes of summarizing the disclosure, certain aspects, advantages and novel features of the inventions have been described herein. It is to be understood that not necessarily all such advantages may be achieved in accordance with any particular embodiment of the invention. Thus, the invention may be embodied or carried out in a manner that achieves or optimizes one advantage or group of advantages as taught herein without necessarily achieving other advantages as may be taught or suggested herein.

### BRIEF DESCRIPTION OF THE DRAWINGS

Figure 1 depicts a radio-frequency (RF) switch having a tuned bias system.
Figure 2 shows that in some embodiments, a field-effect transistor (FET) for a stack can be implemented in a finger configuration.
Figure 3 shows an example side sectional view of a portion indicated in Figure 2.
Figure 4 depicts a stack having a plurality of individual FETs.
Figure 5 shows an example of a bias scheme for a stack of FETs, in which a gate resistor can be provided between the gate of each FET and a common node. The arrangement shown in Figure 5 is not covered by the claims.
Figure 6 depicts examples of paths through which an RF signal can pass or leak when the stack is in an OFF state. The arrangement shown in Figure 6 is not covered by the claims.
Figure 7A depicts example frequency responses of a high DC resistance and a lower DC resistance.
Figure 7B shows that in some embodiments, a switching architecture can be configured so that an R0 FF response remains relatively high for frequencies within a desired range.
Figure 8 shows an example switch configuration having a tuned bias system for a stack of FETs.
Figure 9 shows a circuit representation of the example of Figure 8.
Figure 10 shows that in some embodiments, one or more features of the present disclosure can be implemented in a source/drain bias system.
Figure 11 shows that in some embodiments, one or more features of the present disclosure can be implemented in a body-biasing system.
Figure 12 shows a comparison of an effective OFF resistance (R_{OFF}) of the example RF switch of Figure 9 with that of the example RF switch of Figure 5.
Figure 13 shows an example of an RF switch having a stack of a plurality of FETs configured as, for example, a single-pole-single-throw (SPST) switch.
Figure 14 shows an RF switch configured to switch one or more signals between one or more poles and one or more throws.
Figure 15 shows that in some implementations, the RF switch of Figure 14 can include an RF core and an energy management (EM) core.
Figure 16 shows a more detailed example of the RF core of Figure 14, in an example context of a single-pole-double-throw (SPDT) configuration.
Figure 17 shows an example SPDT configuration in which each switch arm segment includes a plurality of FETs.
Figure 18 shows that in some implementations, controlling of a FET can be facilitated by a circuit configured to bias and/or couple one or more portions of the FET.
Figure 19 shows examples of biasing and/or coupling of different parts of one or more FETs arrange in series.
Figures 20A and 20B show plan and side sectional views of an example finger-based FET device implemented on silicon-on-insulator (SOI).
Figures 21A and 21B show plan and side sectional views of an example multiple-finger FET device implemented on SOI.
Figures 22A-22D show non-limiting examples of how one or more features of the present disclosure can be implemented on one or more semiconductor die.
Figures 23A and 23B show plan view and side view of a packaged module having one or more features as described herein.
Figure 24 shows a schematic diagram of an example switching configuration that can be implemented in the module of Figures 23A and 23B.
Figure 25 depicts an example wireless device having one or more advantageous features described herein.

### DETAILED DESCRIPTION OF SOME EMBODIMENTS

In some radio-frequency (RF) applications such as antenna tuning or some other switching applications, RF switches and passive components can be utilized. Such RF switches can include a plurality of switching elements (e.g., field-effect transistors (FET)). Such switching elements are commonly arranged in a stack configuration to facilitate appropriate handling of power. For example, a higher FET stack height can be utilized to allow an RF switch to withstand high power under mismatch.

When such FETs are in an OFF state, they can be thought of as acting as a shunt "high" impedance respect to ground. Such an OFF stack will typically present a capacitance Coff and an impedance Roff that can create mismatch loss (e.g., due to Coff) and/or dissipative loss (e.g., due to Roff). In a situation where a high voltage is applied to the OFF stack, the dissipative loss due to Roff can become significant (e.g., similar to a tuning or resonant circuit). Such an effect can also reduce the quality factor (Q), and thus usefulness, of a corresponding resonant circuit. In some situations, these dissipative losses can result from the gate, body and/or drain/source resistors used to apply direct-current (DC) bias to the FETs.

Described herein are circuits, devices and methods that can be implemented to address, among others, some or all of the foregoing examples of challenges associated with FET stacks. Although described in the context of FET stacks, it will be understood that one or more features of the present disclosure can also be implemented in switching stacks that utilize other types of switching elements. For example, switching or other type of stacks having diodes or microelectromechanical systems (MEMS) devices (e.g., MEMS capacitors or MEMS switches) as elements can also benefit from implementation of one or more features as described herein.

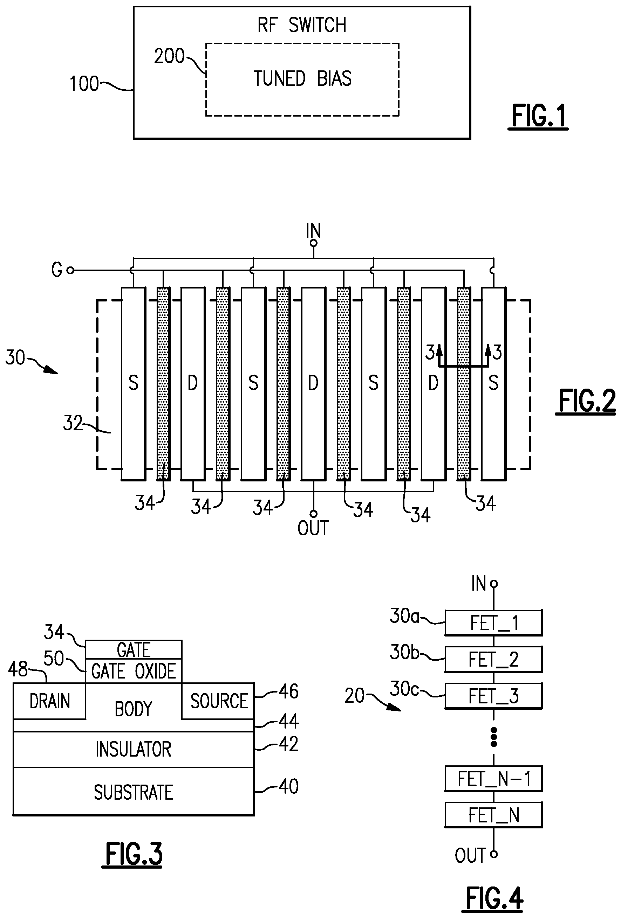

Figure 1 schematically shows an RF switch 100 having a tuned bias system 200. In some embodiments, such a tuned bias system can be implemented to bias some or all of the FETs in a stack to achieve one or more desired functionalities for the stack when the FETs are in an OFF state. Examples of such desired functionalities are described herein in greater detail.

For the purpose of description, it will be understood that FETs can include, for example, metal-oxide-semiconductor FETs (MOSFETs) such as SOI MOSFETs. It will also be understood that FETs as described herein can be implemented in other process technologies, including but not limited to HEMT, SOI, silicon-on-sapphire (SOS), and CMOS technologies.

Figure 2 shows that in some embodiments, a FET 30 for a stack can be implemented in a finger configuration. Although various examples are described herein in the context of such a finger configuration, other FET configurations can also be implemented and benefit from one or more features of the present disclosure.

In the example, the FET 30 is shown to include an active region 32. Although described in the example context of a rectangular shape, it will be understood that other shapes of active region are also possible.

A plurality of source (S) and drain (D) contacts are shown to be implemented in a finger configuration, with gate fingers 34 interleaved therebetween. In some embodiments, each of the source and drain contacts (S, D) can form an ohmic metal contact with the active region 32, and each of the gate fingers 34 can include a metal contact coupled with the active region 32 through a gate oxide layer. Each of the source contacts S can be electrically connected to a first input node In, and each of the drain contacts D can be electrically connected to a first output node Out. It will be understood that each of S and D can be either an input or output, depending on a given layout. Each of the gate fingers 34 can be electrically connected to a gate node G.

Figure 3 shows an example side sectional view of a portion indicated in Figure 2. The example in Figure 3 shows an SOI configuration; however, it will be understood that one or more features of the present disclosure can also be implemented in other types of switching transistors.

In some embodiment, a source-gate-drain unit can include an insulator 42 formed over a substrate 40. A body 44 is shown to be formed over the insulator 42, and source/drain regions 46, 48 are shown to be formed on the body 44. The source/drain regions 46, 48 are shown to be separated by a portion of the body 44 below a gate 34. A gate oxide layer 50 is shown to be provided between the gate 34 and the body 44.

Figure 4 schematically depicts a stack 20 having a plurality of individual FETs 30. N such FETs are shown to be connected in series between an input node (IN) and an output node (OUT), with the quantity N being a positive integer greater than 1. It will be understood that the input and output can be reversed in some embodiments, such that the OUT node receives a signal and the IN node outputs the signal.

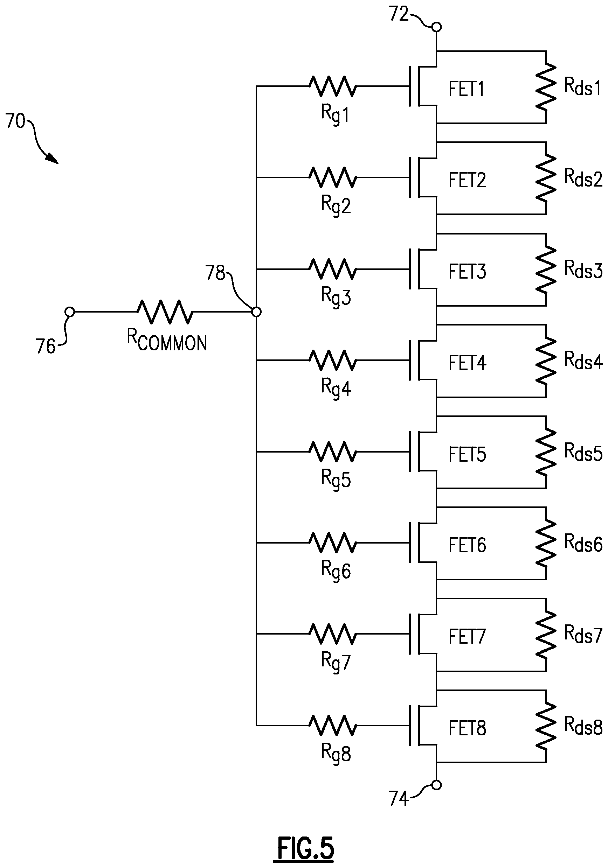

In some configurations, a bias scheme for a stack of FETs can include gate resistors connected from the gate of each FET to a common node. An example of such a configuration is depicted in Figure 5. In an example configuration 70, eight example FETs (FET1, FET2, ..., FET7, FET8) are shown to be arranged in series between ports 72 and 74. Each FET is shown to include a resistance between its drain and source. For example, FET1 is shown to have a resistance R_{ds1} between its drain and source, FET2 is shown to have a resistance R_{ds2} between its drain and source, and so on.

The gates of the eight example FETs are shown to be biased from a DC bias feed point 76 through a common resistance R_{common}, and an individual gate resistance for each of the eight gates (R_{g1} between a common node 78 and the gate of FET1, R_{g2} between the common node 78 and the gate of FET2, and so on). In some embodiments, the common resistance R_{common} may be absent. The gate resistances R_{g1} to R_{g8} may or may not have the same value. Although not shown, a similar biasing network can be provided for the bodies of the FETs.

When configured in the foregoing example manner, the FETs can be turned ON or OFF together. When in the ON state, each FET can be ON so as to allow passage of an RF signal from, for example, the first port 72 to the second port 74. In such a state, the stack as a whole can have an overall resistance of R_{ON} and an overall capacitance of C_{ON}. When in the OFF state, each FET can be OFF so as to generally inhibit passage of such an RF signal between the first and second ports 72, 74. In such a state, the stack as a whole can have an overall resistance of R_{OFF} and an overall capacitance of C_{OFF}.

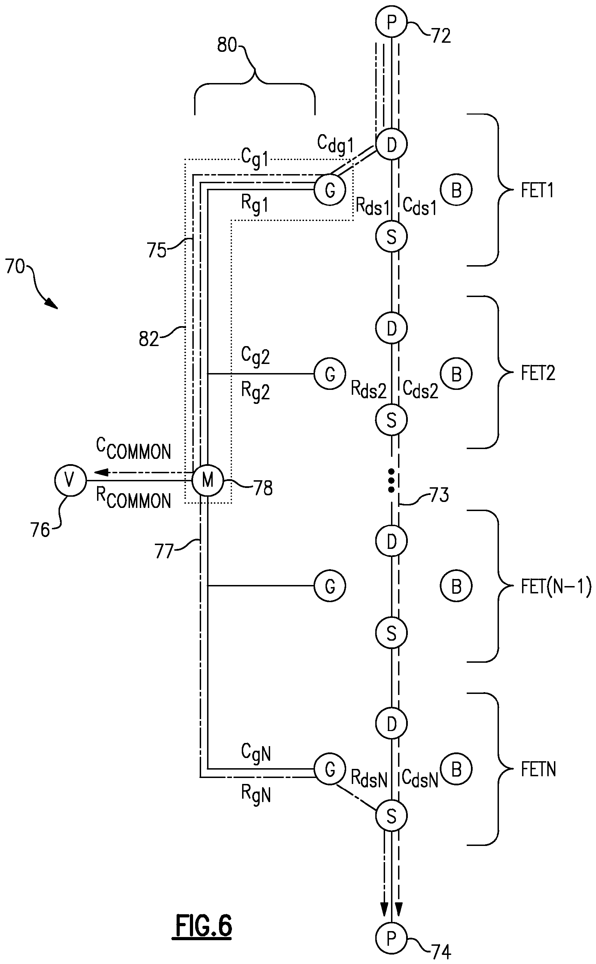

A stack of FETs and its corresponding biasing network, such as the example of Figure 5, can yield a number of paths through which an RF signal can pass or leak when the stack is in the OFF state. Figure 6 depicts examples of such paths that can exist in the example configuration 70 of Figure 5, for an RF signal arriving at the first port (P) 72 when the stack is in the OFF state. In Figure 6, various resistance symbols are not shown, with an understanding that an electrical path provided between two nodes (depicted as a solid line) can have a resistance (by a discrete resistor and/or by property of the path), a capacitance, and/or an inductance. For the purpose of description of Figures 5 and 6, it will be assumed that capacitance and inductance associated with the various paths between nodes can include parasitic effects.

In the example shown in Figure 6, a path 73 (depicted as a dashed line) can be a path through which an RF signal can leak from the first port node (P) 72 to the second port node (P) 74. In some situations, such a path can be considered to have the OFF resistance of the stack (R_{OFF}), where R_{OFF} includes a sum of all the R_{ds} resistances (e.g., R_{ds1} to R_{ds8}) between the ports 72, 74. Selecting appropriate values for the R_{ds} resistances can inhibit or reduce such a leakage of RF signal between the first and second ports 72, 74.

However, and in particular at higher frequencies, at least some of the RF signal provided at the first port 72 can bypass the path 73 through a number of ways. For example, a path 75 can bypass the R_{ds} resistances of the FETs and allow the RF signal to leak to a node (V) 76 associated with the DC bias feed point. Such a path can include path portions between the drain (D) and gate (G) nodes of the first FET (including a parasitic capacitance C_{dg1}), between the gate (G) node and a common node (M) 78 (including a gate resistance R_{g1} and a parasitic capacitance C_{g1}), and between the common node (M) 78 and the DC bias feed point node (V) 76 (including a common resistance R_{common} and a parasitic capacitance Ccommon).

Increasing the value of R_{common} can inhibit or reduce the leakage of RF signal to the DC bias feed point node (V) 76. With such an increase, however, other leakage path can become significant. For example, a path 77 can initially follow the foregoing example path 75 up to the common node (M) 78. From the common node 78, a leaked RF signal can travel to, for example, the second port (P) 74 through path portions between the common node (M) 78 and the gate (G) node of the last FET (FETN) (including a gate resistance R_{gN} and a parasitic capacitance C_{gN}), and between the gate (G) node and the source (S) node of the last FET (including a parasitic capacitance C_{dgN}).

Based on the foregoing examples of paths (e.g., 75, 77) that can exist, one can note that a bias circuit for a stack of FETs can provide a network of RF paths when the stack is in the OFF state. Accordingly, there is a limit to what can be achieved to inhibit or reduce RF leakage by simply increasing resistance values.

It is also noted that a significant RF path to ground can be through the parastic capacitance of, for example, some or all the resistors associated with the biasing circuit. In such a context, a large resistor may present a higher impedance to an RF signal; but its intrsinsic parasitic capacitance to ground may provide more influence to the RF signal than the increased resistance. Thus, in some situations, there can be an optimum resistance/capacitance combination for a given resistor technology; and such a combination can determine how much resistance is effective. Increasing the resistance beyond such an optimum combination can result in a decrease in the effective resistance to the RF signal. In such a situation, more of the RF signal can be undesirably dissipated in the resistor(s) when flowing to ground; and the quality-factor (Q) of the FET stack can be degraded.

In some implementations, the present disclosure relates to a switching architecture having an increased effective OFF resistance (R_{OFF}) over a desired range of frequency to thereby provide improved Q_{OFF} within some or all of the same frequency range. Q_{OFF} can be expressed as *Q_{OFF}* = *2πfR_{OFF}C_{OFF}*, where f is frequency, and both of *R_{OFF}* and *C_{OFF}* being dependent on frequency. Accordingly, R_{OFF} of a switch can be configured to yield an increase of a desired frequency range.

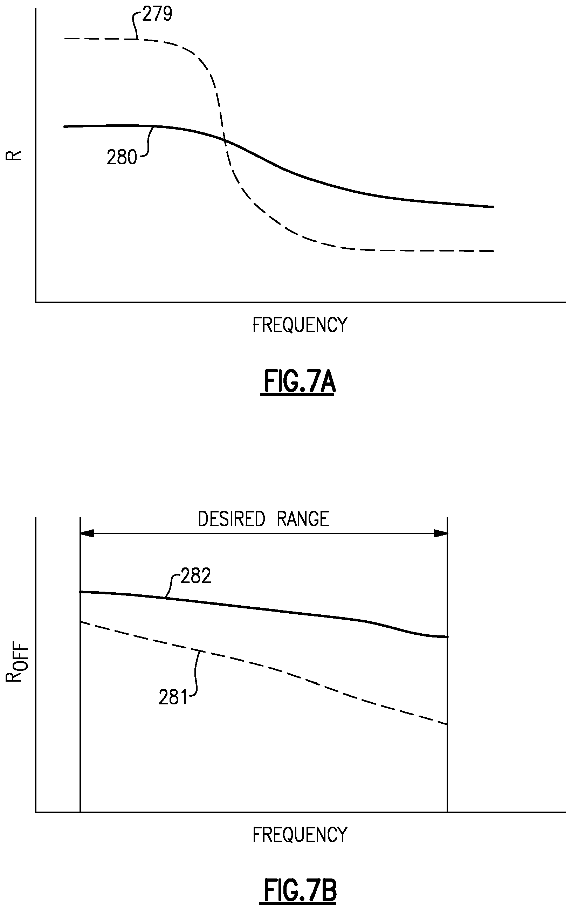

As described herein, a given resistor can have a frequency response where effective resistance decreases when frequency increases beyond some value. For example, Figure 7A depicts frequency responses of two resistors - one having a high DC resistance value (curve 279), and one having a lower DC resistance value (curve 280). At lower frequencies, the curve 279 is shown to be significantly higher than the curve 280. However, at higher frequencies, the curve 279 is shown to be significantly lower than the curve 280. As described herein, such a decrease in effective resistance at higher frequencies can result from parasitic capacitance associated with the resistor.

Figure 7B shows that in some embodiments, a switching architecture can be configured so that an R_{OFF} response remains relatively high for frequencies within a desired range. For example, suppose that frequency response of R_{OFF} as a whole for the example configuration of Figures 5 and 6 can be represented by a response curve 281. As described herein, a switching architecture having one or more features as described herein can yield an improved R_{OFF} response 282 that is higher than the response 281 throughout the desired frequency range. Accordingly, Q performance can be improved for the same frequency range.

In some embodiments, such an overall increase in R_{OFF} within a desired frequency range can be achieved by using selected resistances as described herein, where more benefit is gained from increase in resistance than performance loss associated with parasitic capacitance. Various examples of switch configurations that can yield the foregoing improvement are described herein in greater detail.

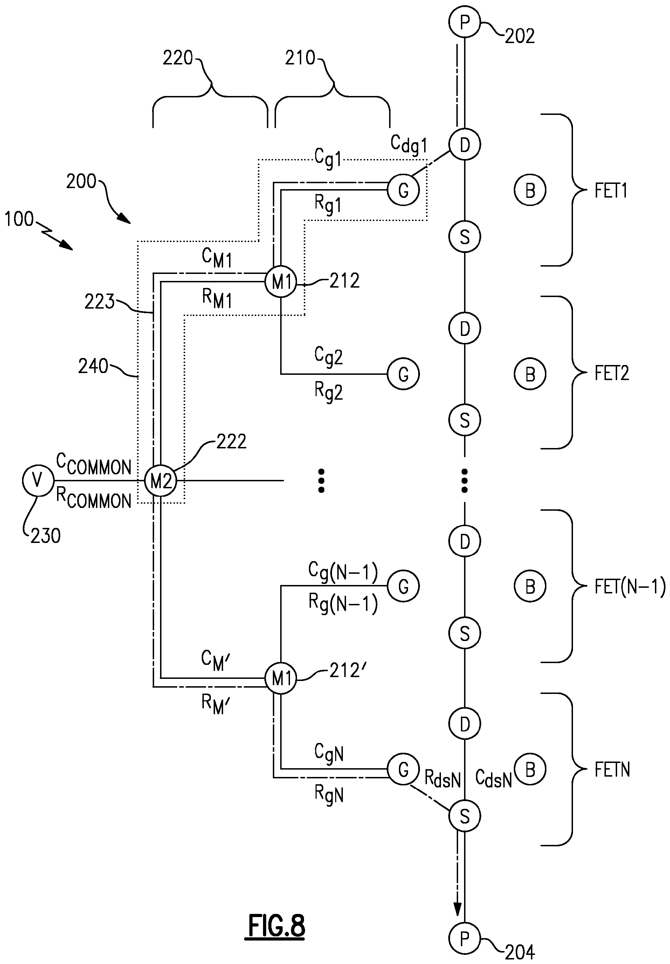

Figure 8 shows an example switch configuration 100 having a tuned bias system 200 for a stack of FETs between ports 202, 204. In such a configuration, an RF signal at port 202 in an OFF state of the switch can leak or experience loss in a number of ways. For example, leakage to ground can occur through parasitic capacitance (C_{g}) of each gate resistor R_{g} (e.g, through parasitic capacitance C_{g1} of R_{g1}, parasitic capacitance C_{g2} of R_{g2}, etc.). In another example, leakage to a common port 230 can occur through a path that includes a portion indicated as 240. Within such a portion, further leakage to ground can occur through parasitic capacitances associated with various resistors (e.g., R_{M1} and R_{common}). In yet another example, leakage to the other port 204 can occur through a path indicated as 223. Along such a path, further leakage to ground can occur through parasitic capacitances associated with various resistors along the path.

In some embodiments, the foregoing examples of leakage paths can be addressed so as to yield an overall increase in R_{OFF}, and thereby an improvement in Q_{OFF}, within a desired frequency range. In the example configuration of Figures 5 and 6, all of the gate resistors (e.g., R_{g1} to R_{g8}) are connected to a common node 78. Thus, efforts to adress leakage associated with each path between a given gate and the common node 78 is essentially limited to variation of gate resistance. Accordingly, an increase in gate resistance to reduce leakage to the common node 78 can result in a decrease in effective resistance to ground-leakage through the gate resistance for frequencies in a desired range.

However, in the example configuration of Figure 8, a path between a given gate and a common node 222 includes two separate resistors. For example, the path generally indicated as 240 between the first gate and the common node 222 includes a gate resistor R_{g1} and an additional resistor R_{M1}. Thus, ground-leakage associated with R_{g1} can be addressed by R_{g1} itself, and leakage to the common node can be addressed by R_{M1}. Examples of such flexibility in addressing the various leakage paths are described herein in greater detail.

In the example of Figure 8, introduction of an additional layer of gate resistance network in the biasing system 200 can facilitate the foregoing design flexibility that yields an increased R_{OFF} and therefore an improved Q performance. In the biasing system 70 of Figure 6, a gate biasing distribution layer generally indicated as 80 includes N resistive paths corresponding to N gate resistances (R_{g1}, R_{g2}, ..., R_{gN}). In the context of the example circuit of Figure 5, N has a value of 8. Such N resisive paths are all connected to the node (M) 78, thereby making each resistive path susceptible to RF leakage to ground. Thus, and as described herein, an increase in DC resistance of such a path (e.g., the first gate resistance path corresponding to R_{g1}) to inhibit RF passage in the OFF state can result in a decrease in effective resistance at an operating frequency.

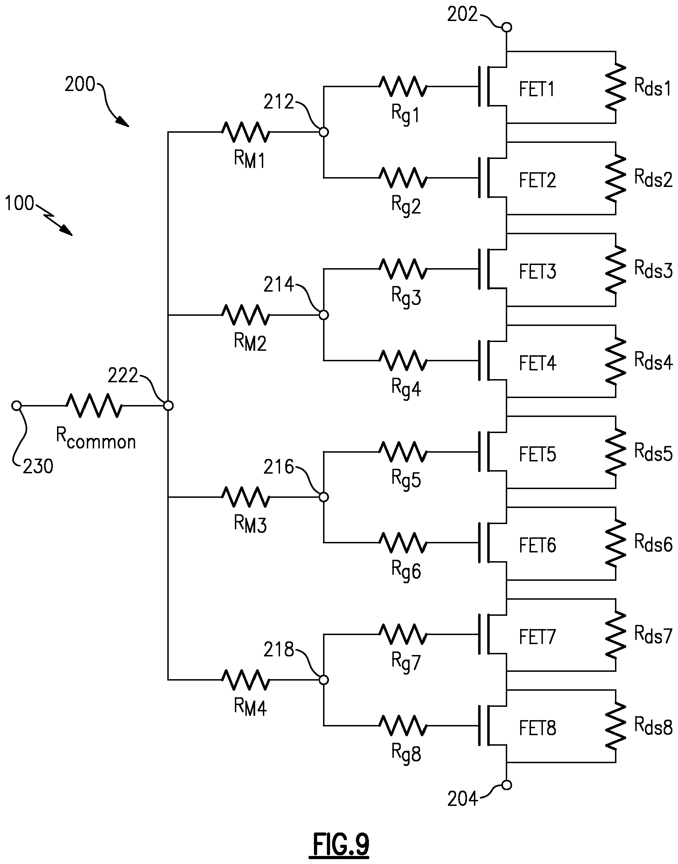

In the biasing system 200 of Figure 8, a gate biasing distribution layer generally indicated as 210 is shown to be connected to the gates of the N FETs. Such a distribution layer (210) can include a plurality of nodes M1 (indicated as 212, 212'), with each node M1 being connected to one or more FETs through respective resistive paths. For example, the first M1 node (212) is shown to be connected to the gate of the first FET (FET1 ) by a resistive path having resistance R_{g1} , and to the gate of the second FET (FET2) by a resistive path having resistance R_{g2}. Similarly, the last M1 node (212') is shown to be connected to the gate of the second-to-last FET (FET(N-1 )) by a resistive path having resistance R_{g(N-1)}, and to the gate of the last FET (FETN) by a resistive path having resistance R_{gN}. In the corresponding circuit representation of Figure 9, the eight example FETs are connected to four of such nodes (M1 in Figure 8, and 212, 214, 216, 218 in Figure 9), with each M1 node being connected to two FETs. It will be understood that an M1 node can be connected to more or less FETs. But in claim 1 each 'first node' is connected to more than one FET.

Thus, one can see that for the example biasing system 200 of Figures 8 and 9, a common node (M2) 222 is connected to each gate by two resistances R_{M} and R_{g} associated with their layers in a distribution configuration. In contrast, the common node (M) node 78 of the example biasing system 70 is connected to each gate by one resistance R_{g}.

In the biasing system 200 of Figure 8, a gate biasing distribution layer generally indicated as 220 is shown to connect the M1 nodes of the distribution layer 210 to the common node M2 (222). The first M1 node (212 in Figure 9) is shown to be connected to the common node M2 (222) through a resistive path having resistance R_{M1}. Similarly, the second M1 node (214 in Figure 9) is connected to the common node M2 (222) through a resistive path having resistance R_{M2}; the third M1 node (216 in Figure 9) is connected to the common node M2 (222) through a resistive path having resistance R_{M3}; and the fourth M1 node (218 in Figure 9) is connected to the common node M2 (222) through a resistive path having resistance R_{M4}.

In the biasing system 200 of Figure 8, the common node M2 (222) is shown to be connected to a DC bias feed point node (V) 230 through a resistive path having resistance Rcommon. Such a resistance may or may not be the same as Rcommon of the example of Figures 5 and 6.

Figure 9 shows a circuit representation of the example biasing system 200 described in reference to Figure 8. Based on the foregoing description in reference to Figures 8 and 9, one can see that an addition of a gate biasing distribution layer allows flexibility in how various distribution resistances can be configured, including being able to address different RF leakage paths.

In the example biasing system 200 of Figures 8 and 9, one additional gate biasing distribution layer is included. It will be understood that more than one of such additional distribution layer can also be implemented.

In some embodiments, various resistances (e.g., resistors) of the biasing system 200 can be configured to allow efficient distribution of gate biasing signals to the FETs from a common DC bias feed point node, and to facilitate the reduction of RF loss through various paths. For example, values of the gate resistors R_{g1}, R_{g2}, ..., R_{g8} of the biasing system 200 (Figure 9) can be decreased relative to the gate resistors R_{g1}, R_{g2}, ..., R_{g8} of the biasing system 70 (Figure 5) to reduce RF loss to ground through the gate resistors. Such reduction in values of gate resistors can result in lower ground-leakage through each of the gate resistors. When the effects of all of the gate resistors are combined, reduction in ground-leakage can be very significant, and the resulting improvement in Q performance can also be very significant.

In the example biasing system 200 of Figures 8 and 9, each of the additional resistors R_{M} can introduce an additional leakage path to ground. However, such resistors can be selected so that any resulting degradation in Q due to the additional ground-leakage is relatively small compared to the improvement in Q performance due to the foregoing reduction in ground-leakage through the reduced gate resistors. Accordingly, the net effect of the selected gate resistors (R_{g}) and the additional resistors (R_{M}) can yield a significant improvement in Q performance.

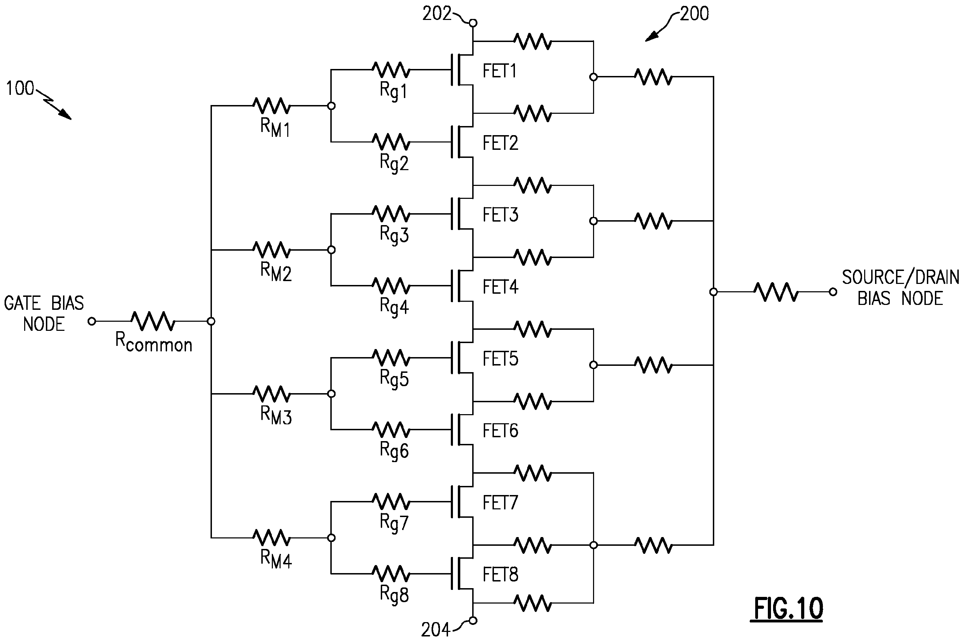

Further, the resistors R_{M} can be selected to provide sufficiently high resistance to reduce RF leakages such as between each gate and the common node 222 (e.g., path 240 in Figure 8), and through the example path 223 between the first and last gates. Accordingly, additional improvement in overall Q performance can be obtained by use of such additional resistors (R_{M}). An example of such improvement in overall Q performance by way of increased R_{OFF} is described herein in reference to Figure 10.

In some embodiments, the gate resistors R_{g1}, R_{g2}, ..., R_{g8} of the biasing system 200 can have a same resistance value, or different resistance values. For example, one or more gate resistors (e.g., R_{g1}) closer to an RF input port (e.g., 202 in Figure 9) can have a higher resistance value than other gate resistors associated with downstream FETs. Similarly, one or more gate resistors (e.g, R_{g8}) closer to an RF output port (e.g., 204 in Figure 9) can have a lower resistance value than other gate resistors associated with upstream FETs.

In some embodiments, the foregoing example of varying values of gate resistors can accommodate the OFF state of the RF switch 100. When the RF switch 100 is in the ON state, it may be desirable to have a common value for all of the gate resistors. In such a situation, the common value of the gate resistors can be selected to accommodate the ON state, as well as be appropriate as described herein to accommodate the reduced RF loss when in the OFF state.

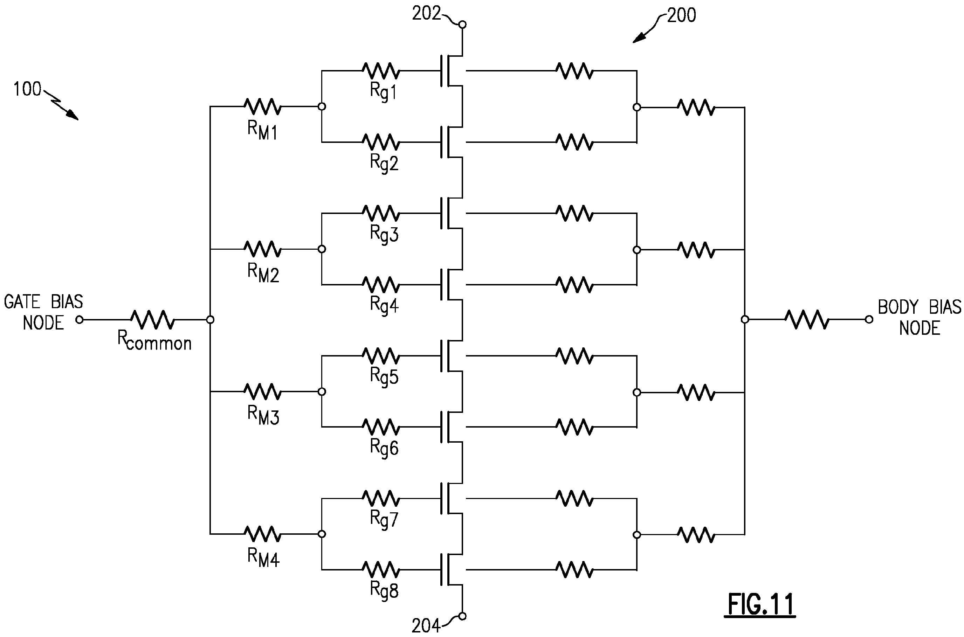

Various examples described herein in reference to Figures 8 and 9 relate to gate biasing systems. It will be understood that one or more features of the present disclosure can also be implemented in circuits associated with other parts of the FETs. For example, the drain-to-source resistors (e.g., R_{ds1}, R_{ds2}, ..., R_{ds8}) can be replaced by a bias system 200 similar to the example described for the gate resistors (e.g., Figure 9). Such an example source/drain bias system is shown in Figure 10. In another example, a body-biasing system 200 can also be configured in a similar manner. Such an example body-biasing system is shown in Figure 11.

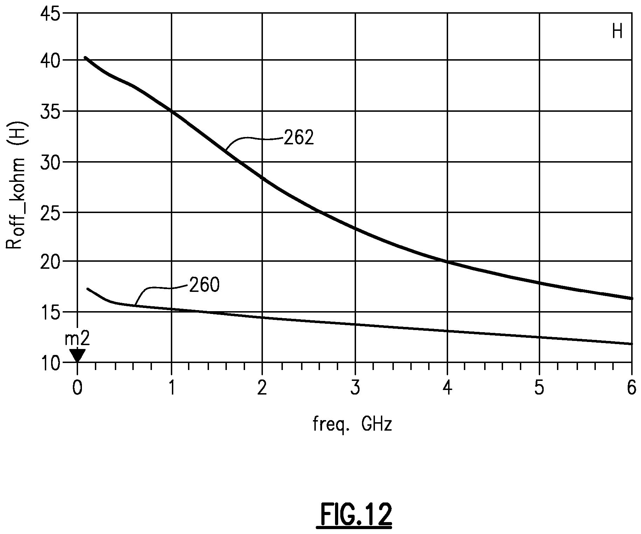

Figure 12 shows a comparison of an effective OFF resistance (R_{OFF}) of the example RF switch 100 of Figure 9 with that of the example RF switch 70 of Figure 5. Plotted as a function of frequency of an RF signal arriving at an input port (e.g., 202 in Figure 9 and 72 in Figure 5), the upper curve 262 is for the RF switch 100, and the lower curve 260 is for the RF switch 70. Values of various resistors that yield the example frequency responses of Figure 12 are listed in Table 1. One can see that the RF switch 100 provides a significantly higher R_{OFF} resistance for the RF signal at the shown range than the RF switch 70. As described herein, such increase in R_{OFF} resistance can be achieved without necessarily increasing the parasitic capacitance and thereby degrading the Q performance.

**Table 1**

| Switch | Resistor | Value (KΩ) |
|---|---|---|
| 70 in Figure 5 | Rcommon | 20 |
| 70 in Figure 5 | R_{g1}, R_{g2}, ..., R_{g8} | 170 |
| 100 in Figure 9 | Rcommon | 20 |
| 100 in Figure 9 | R_{g1}, R_{g2}, ..., R_{g8} | 120 |
| 100 in Figure 9 | R_{M1}, R_{M2}, R_{M3}, R_{M4} | 65 |

In Table 1, it is noted that the gate resistance value for the example switch 100 of Figure 9 is at a reduced value of 120 KΩ, compared to a value of 170 KΩ for the example switch 70 of Figure 5. It is also noted that the additional resistors that couple the gate resistors to the common node (222 in Figure 9) have a value of 65 KΩ.

### Examples of Switching Applications:

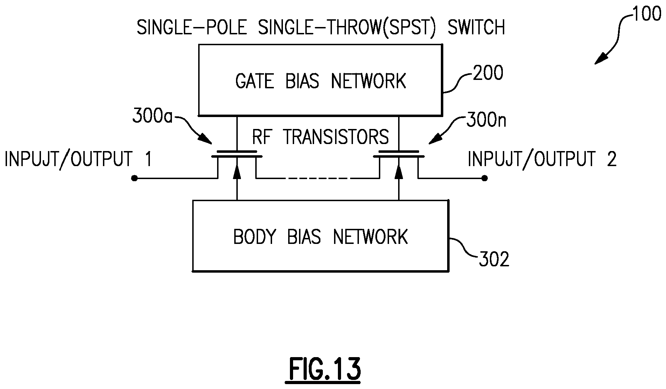

In some embodiments, a FET stack having two or more FETs can be implemented as an RF switch. Figure 13 shows an example of an RF switch 100 having a stack of a plurality of FETs (e.g., N of such FETs 300a to 300n). Such a switch can be configured as a single-pole-single-throw (SPST) switch. Although described in the context of such an example, it will be understood that one or more of stacks can be implemented in other switch configurations.

In the example of Figure 13, each of the FETs (300a to 300n) can be controlled by a respective gate bias network 200 and a body bias network 302. In some embodiments, either or both of such bias networks can include one or more features as described herein.

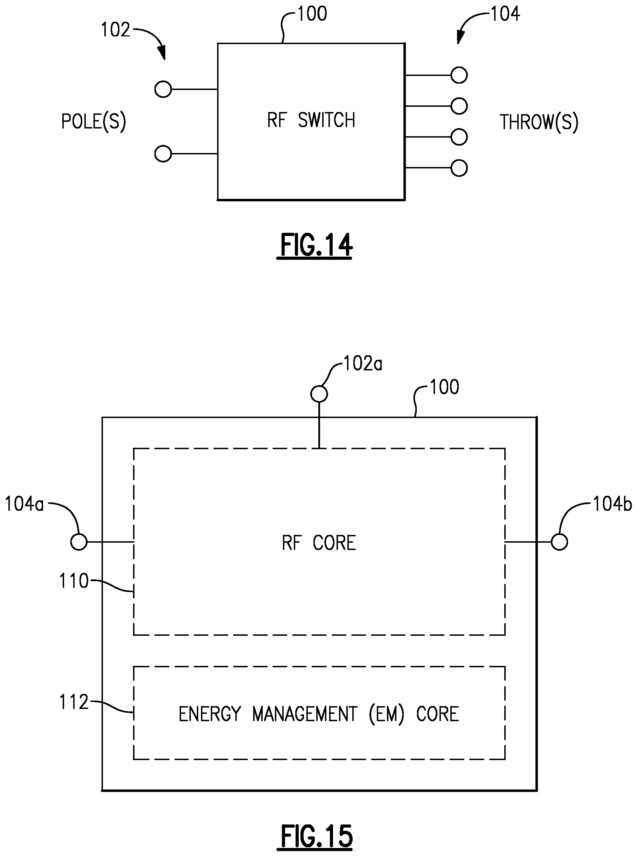

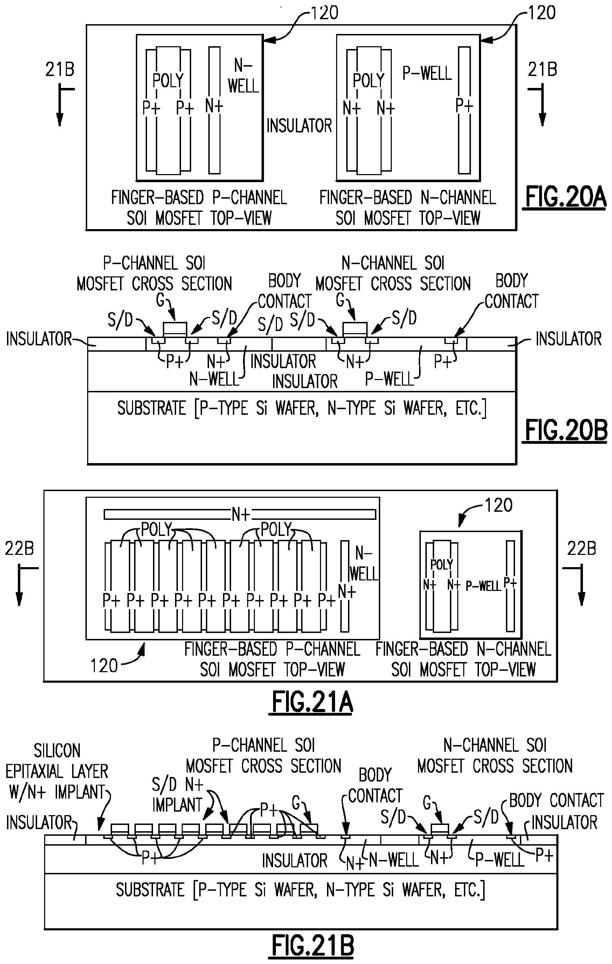

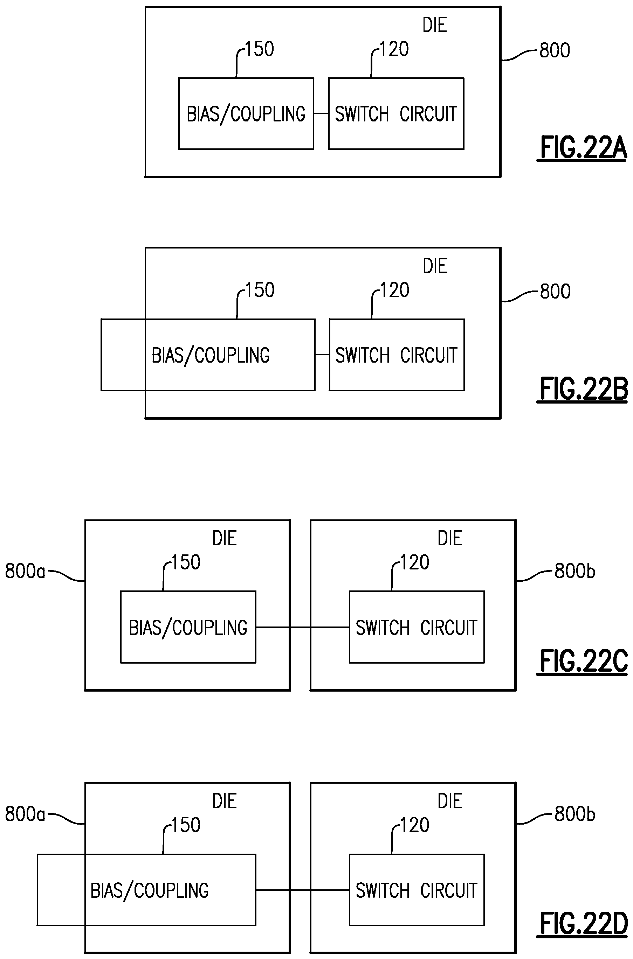

Figures 14-19 show non-limiting examples of switching applications where one or more features of the present disclosure can be implemented. Figures 20 and 21 show examples where one or more features of the present disclosure can be implemented in SOI devices. Figure 22-25 show examples of how one or more features of the present disclosure can be implemented in different products.

### Example Components of a Switching Device:

Figure 14 shows a radio-frequency (RF) switch 100 configured to switch one or more signals between one or more poles 102 and one or more throws 104. In some embodiments, such a switch can be based on one or more field-effect transistors (FETs) such as silicon-on-insulator (SOI) FETs. When a particular pole is connected to a particular throw, such a path is commonly referred to as being closed or in an ON state. When a given path between a pole and a throw is not connected, such a path is commonly referred to as being open or in an OFF state.

Figure 15 shows that in some implementations, the RF switch 100 of Figure 14 can include an RF core 110 and an energy management (EM) core 112. The RF core 110 can be configured to route RF signals between the first and second ports. In the example single-pole-double-throw (SPDT) configuration shown in Figure 15, such first and second ports can include a pole 102a and a first throw 104a, or the pole 102a and a second throw 104b.

In some embodiments, the EM core 112 can be configured to supply, for example, voltage control signals to the RF core. The EM core 112 can be further configured to provide the RF switch 100 with logic decoding and/or power supply conditioning capabilities.

In some embodiments, the RF core 110 can include one or more poles and one or more throws to enable passage of RF signals between one or more inputs and one or more outputs of the switch 100. For example, the RF core 110 can include a single-pole double-throw (SPDT or SP2T) configuration as shown in Figure 15.

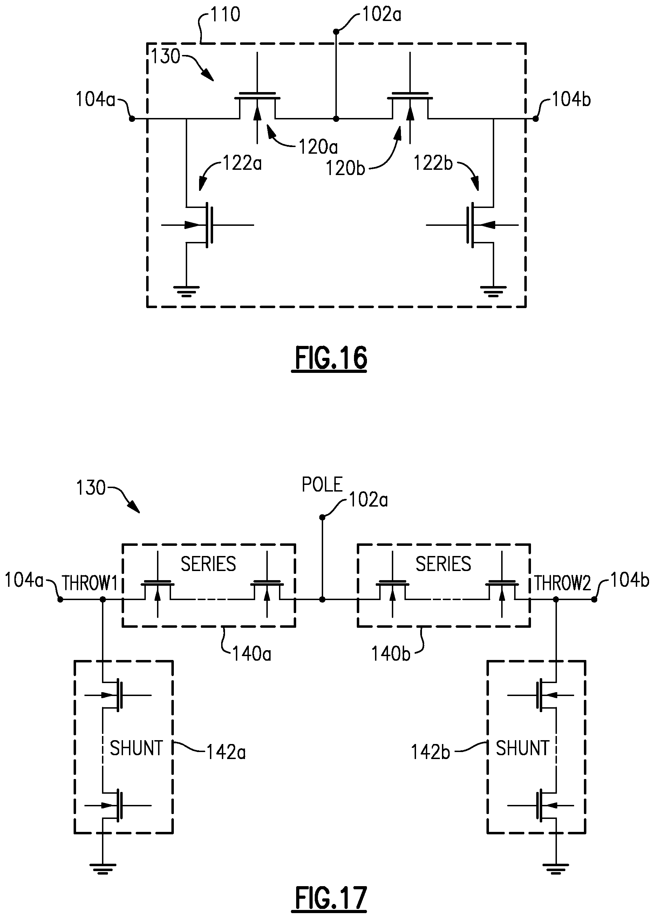

In the example SPDT context, Figure 16 shows a more detailed example configuration of an RF core 110. The RF core 110 is shown to include a single pole 102a coupled to first and second throw nodes 104a, 104b via first and second transistors (e.g., FETs) 120a, 120b. The first throw node 104a is shown to be coupled to an RF ground via an FET 122a to provide shunting capability for the node 104a. Similarly, the second throw node 104b is shown to be coupled to the RF ground via an FET 122b to provide shunting capability for the node 104b.

In an example operation, when the RF core 110 is in a state where an RF signal is being passed between the pole 102a and the first throw 104a, the FET 120a between the pole 102a and the first throw node 104a can be in an ON state, and the FET 120b between the pole 102a and the second throw node 104b can be in an OFF state. For the shunt FETs 122a, 122b, the shunt FET 122a can be in an OFF state so that the RF signal is not shunted to ground as it travels from the pole 102a to the first throw node 104a. The shunt FET 122b associated with the second throw node 104b can be in an ON state so that any RF signals or noise arriving at the RF core 110 through the second throw node 104b is shunted to the ground so as to reduce undesirable interference effects to the pole-to-first-throw operation.

Although the foregoing example is described in the context of a single-pole-double-throw configuration, it will be understood that the RF core can be configured with other numbers of poles and throws. For example, there may be more than one poles, and the number of throws can be less than or greater than the example number of two.

In the example of Figure 16, the transistors between the pole 102a and the two throw nodes 104a, 104b are depicted as single transistors. In some implementations, such switching functionalities between the pole(s) and the throw(s) can be provided by switch arm segments, where each switch arm segment includes a plurality of transistors such as FETs.

An example RF core configuration 130 of an RF core having such switch arm segments is shown in Figure 17. In the example, the pole 102a and the first throw node 104a are shown to be coupled via a first switch arm segment 140a. Similarly, the pole 102a and the second throw node 104b are shown to be coupled via a second switch arm segment 140b. The first throw node 104a is shown to be capable of being shunted to an RF ground via a first shunt arm segment 142a. Similarly, the second throw node 104b is shown to be capable of being shunted to the RF ground via a second shunt arm segment 142b.

In an example operation, when the RF core 130 is in a state where an RF signal is being passed between the pole 102a and the first throw node 104a, all of the FETs in the first switch arm segment 140a can be in an ON state, and all of the FETs in the second switch arm segment 104b can be in an OFF state. The first shunt arm 142a for the first throw node 104a can have all of its FETs in an OFF state so that the RF signal is not shunted to ground as it travels from the pole 102a to the first throw node 104a. All of the FETs in the second shunt arm 142b associated with the second throw node 104b can be in an ON state so that any RF signals or noise arriving at the RF core 130 through the second throw node 104b is shunted to the ground so as to reduce undesirable interference effects to the pole-to-first-throw operation.

Again, although described in the context of an SP2T configuration, it will be understood that RF cores having other numbers of poles and throws can also be implemented.

In some implementations, a switch arm segment (e.g., 140a, 140b, 142a, 142b) can include one or more semiconductor transistors such as FETs. In some embodiments, an FET may be capable of being in a first state or a second state and can include a gate, a drain, a source, and a body (sometimes also referred to as a substrate). In some embodiments, an FET can include a metal-oxide-semiconductor field effect transistor (MOSFET). In some embodiments, one or more FETs can be connected in series forming a first end and a second end such that an RF signal can be routed between the first end and the second end when the FETs are in a first state (e.g., ON state).

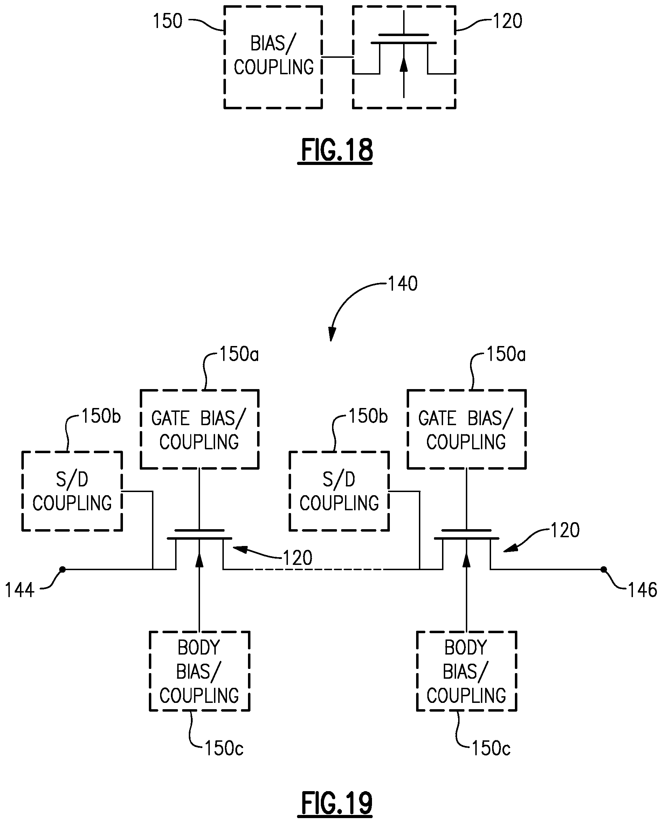

At least some of the present disclosure relates to how a FET or a group of FETs can be controlled to provide switching functionalities in desirable manners. Figure 18 schematically shows that in some implementations, such controlling of an FET 120 can be facilitated by a circuit 150 configured to bias and/or couple one or more portions of the FET 120. In some embodiments, such a circuit 150 can include one or more circuits configured to bias and/or couple a gate of the FET 120, bias and/or couple a body of the FET 120, and/or couple a source/drain of the FET 120.

Schematic examples of how such biasing and/or coupling of different parts of one or more FETs are described in reference to Figure 19. In Figure 19, a switch arm segment 140 (that can be, for example, one of the example switch arm segments 140a, 140b, 142a, 142b of the example of Figure 17) between nodes 144, 146 is shown to include a plurality of FETs 120. Operations of such FETs can be controlled and/or facilitated by a gate bias/coupling circuit 150a, and a body bias/coupling circuit 150c, and/or a source/drain coupling circuit 150b.

### Gate Bias/Couipling Circuit

In the example shown in Figure 19, the gate of each of the FETs 120 can be connected to the gate bias/coupling circuit 150a to receive a gate bias signal and/or couple the gate to another part of the FET 120 or the switch arm 140. In some implementations, designs or features of the gate bias/coupling circuit 150a can improve performance of the switch arm 140. Such improvements in performance can include, but are not limited to, device insertion loss, isolation performance, power handling capability and/or switching device linearity.

### Body Bias/Coupling Circuit

As shown in Figure 19, the body of each FET 120 can be connected to the body bias/coupling circuit 150c to receive a body bias signal and/or couple the body to another part of the FET 120 or the switch arm 140. In some implementations, designs or features of the body bias/coupling circuit 150c can improve performance of the switch arm 140. Such improvements in performance can include, but are not limited to, device insertion loss, isolation performance, power handling capability and/or switching device linearity.

### Source/Drain Coupling Circuit

As shown in Figure 19, the source/drain of each FET 120 can be connected to the coupling circuit 150b to couple the source/drain to another part of the FET 120 or the switch arm 140. In some implementations, designs or features of the coupling circuit 150b can improve performance of the switch arm 140. Such improvements in performance can include, but are not limited to, device insertion loss, isolation performance, power handling capability and/or switching device linearity.

### Examples of Switching Performance Parameters:

### Insertion Loss

A switching device performance parameter can include a measure of insertion loss. A switching device insertion loss can be a measure of the attenuation of an RF signal that is routed through the RF switching device. For example, the magnitude of an RF signal at an output port of a switching device can be less than the magnitude of the RF signal at an input port of the switching device. In some embodiments, a switching device can include device components that introduce parasitic capacitance, inductance, resistance, or conductance into the device, contributing to increased switching device insertion loss. In some embodiments, a switching device insertion loss can be measured as a ratio of the power or voltage of an RF signal at an input port to the power or voltage of the RF signal at an output port of the switching device. Decreased switching device insertion loss can be desirable to enable improved RF signal transmission.

### Isolation

A switching device performance parameter can also include a measure of isolation. Switching device isolation can be a measure of the RF isolation between an input port and an output port an RF switching device. In some embodiments, it can be a measure of the RF isolation of a switching device while the switching device is in a state where an input port and an output port are electrically isolated, for example while the switching device is in an OFF state. Increased switching device isolation can improve RF signal integrity. In certain embodiments, an increase in isolation can improve wireless communication device performance.

### Intermodulation Distortion

A switching device performance parameter can further include a measure of intermodulation distortion (IMD) performance. Intermodulation distortion (IMD) can be a measure of non-linearity in an RF switching device.

IMD can result from two or more signals mixing together and yielding frequencies that are not harmonic frequencies. For example, suppose that two signals have fundamental frequencies f₁ and f₂ (f2 > f₁) that are relatively close to each other in frequency space. Mixing of such signals can result in peaks in frequency spectrum at frequencies corresponding to different products of fundamental and harmonic frequencies of the two signals. For example, a second-order intermodulation distortion (also referred to as IMD2) is typically considered to include frequencies f₁+f₂ f₂-f₁, 2f₁, and 2f₂. A third-order IMD (also referred to as IMD3) is typically considered to include 2f₁+f₂, 2f₁-f₂, f₁+2f₂, f₁-2f₂. Higher order products can be formed in similar manners.

In general, as the IMD order number increases, power levels decrease. Accordingly, second and third orders can be undesirable effects that are of particular interest. Higher orders such as fourth and fifth orders can also be of interest in some situations.

In some RF applications, it can be desirable to reduce susceptibility to interference within an RF system. Non linearity in RF systems can result in introduction of spurious signals into the system. Spurious signals in the RF system can result in interference within the system and degrade the information transmitted by RF signals. An RF system having increased non-linearity can demonstrate increased susceptibility to interference. Non-linearity in system components, for example switching devices, can contribute to the introduction of spurious signals into the RF system, thereby contributing to degradation of overall RF system linearity and IMD performance.

In some embodiments, RF switching devices can be implemented as part of an RF system including a wireless communication system. IMD performance of the system can be improved by increasing linearity of system components, such as linearity of an RF switching device. In some embodiments, a wireless communication system can operate in a multi-band and/or multi-mode environment. Improvement in intermodulation distortion (IMD) performance can be desirable in wireless communication systems operating in a multi-band and/or multi-mode environment. In some embodiments, improvement of a switching device IMD performance can improve the IMD performance of a wireless communication system operating in a multi-mode and/or multi-band environment.

Improved switching device IMD performance can be desirable for wireless communication devices operating in various wireless communication standards, for example for wireless communication devices operating in the LTE communication standard. In some RF applications, it can be desirable to improve linearity of switching devices operating in wireless communication devices that enable simultaneous transmission of data and voice communication. For example, improved IMD performance in switching devices can be desirable for wireless communication devices operating in the LTE communication standard and performing simultaneous transmission of voice and data communication (e.g., SVLTE).

### High Power Handling Capability

In some RF applications, it can be desirable for RF switching devices to operate under high power while reducing degradation of other device performance parameters. In some embodiments, it can be desirable for RF switching devices to operate under high power with improved intermodulation distortion, insertion loss, and/or isolation performance.

In some embodiments, an increased number of transistors can be implemented in a switch arm segment of a switching device to enable improved power handling capability of the switching device. For example, a switch arm segment can include an increased number of FETs connected in series, an increased FET stack height, to enable improved device performance under high power. However, in some embodiments, increased FET stack height can degrade the switching device insertion loss performance.

### Examples of FET Structures and Fabrication Process Technologies:

A switching device can be implemented on-die, off-die, or some combination thereof. A switching device can also be fabricated using various technologies. In some embodiments, RF switching devices can be fabricated with silicon or silicon-on-insulator (SOI) technology.

As described herein, an RF switching device can be implemented using silicon-on-insulator (SOI) technology. In some embodiments, SOI technology can include a semiconductor substrate having an embedded layer of electrically insulating material, such as a buried oxide layer beneath a silicon device layer. For example, an SOI substrate can include an oxide layer embedded below a silicon layer. Other insulating materials known in the art can also be used.

Implementation of RF applications, such as an RF switching device, using SOI technology can improve switching device performance. In some embodiments, SOI technology can enable reduced power consumption. Reduced power consumption can be desirable in RF applications, including those associated with wireless communication devices. SOI technology can enable reduced power consumption of device circuitry due to decreased parasitic capacitance of transistors and interconnect metallization to a silicon substrate. Presence of a buried oxide layer can also reduce junction capacitance or use of high resistivity substrate, enabling reduced substrate related RF losses. Electrically isolated SOI transistors can facilitate stacking, contributing to decreased chip size.

In some SOI FET configurations, each transistor can be configured as a finger-based device where the source and drain are rectangular shaped (in a plan view) and a gate structure extends between the source and drain like a rectangular shaped finger. Figures 20A and 20B show plan and side sectional views of an example finger-based FET device implemented on SOI. As shown, FET devices described herein can include a p-type FET or an n-type FET. Thus, although some FET devices are described herein as p-type devices, it will be understood that various concepts associated with such p-type devices can also apply to n-type devices.

As shown in Figures 20A and 20B, a pMOSFET can include an insulator layer formed on a semiconductor substrate. The insulator layer can be formed from materials such as silicon dioxide or sapphire. An n-well is shown to be formed in the insulator such that the exposed surface generally defines a rectangular region. Source (S) and drain (D) are shown to be p-doped regions whose exposed surfaces generally define rectangles. As shown, S/D regions can be configured so that source and drain functionalities are reversed.

Figures 20A and 20B further show that a gate (G) can be formed on the n-well so as to be positioned between the source and the drain. The example gate is depicted as having a rectangular shape that extends along with the source and the drain. Also shown is an n-type body contact. Formations of the rectangular shaped well, source and drain regions, and the body contact can be achieved by a number of known techniques.

Figures 21A and 21B show plan and side sectional views of an example of a multiple-finger FET device implemented on SOI. Formations of rectangular shaped n-well, rectangular shaped p-doped regions, rectangular shaped gates, and n-type body contact can be achieved in manners similar to those described in reference to Figures 20A and 20B.

The example multiple-finger FET device of Figures 21A and 21B can be configured so that the source regions are electrically connected together to a source node, and the drain regions are connected together to a drain node. The gates can also be connected together to a gate node. In such an example configuration, a common gate bias signal can be provided through the gate node to control flow of current between the source node and the drain node.

In some implementations, a plurality of the foregoing multi-finger FET devices can be connected in series as a switch to allow handling of high power RF signals. Each FET device can divide the overall voltage drop associated with power dissipation at the connected FETs. A number of such multi-finger FET devices can be selected based on, for example, power handling requirement of the switch.

### Examples of Implementations in Products:

Various examples of FET-based switch circuits described herein can be implemented in a number of different ways and at different product levels. Some of such product implementations are described by way of examples.

### Semiconductor Die Implementation

Figures 22A-22D show non-limiting examples of such implementations on one or more semiconductor die. Figure 22A shows that in some embodiments, a switch circuit 120 and a bias/coupling circuit 150 having one or more features as described herein can be implemented on a die 800. Figure 22B shows that in some embodiments, at least some of the bias/coupling circuit 150 can be implemented outside of the die 800 of Figure 22A.

Figure 22C shows that in some embodiments, a switch circuit 120 having one or more features as described herein can be implemented on a first die 800a, and a bias/coupling circuit 150 having one or more features as described herein can be implemented on a second die 800b. Figure 22D shows that in some embodiments, at least some of the bias/coupling circuit 150 can be implemented outside of the first die 800a of Figure 22C.

### Packaged Module Implementation

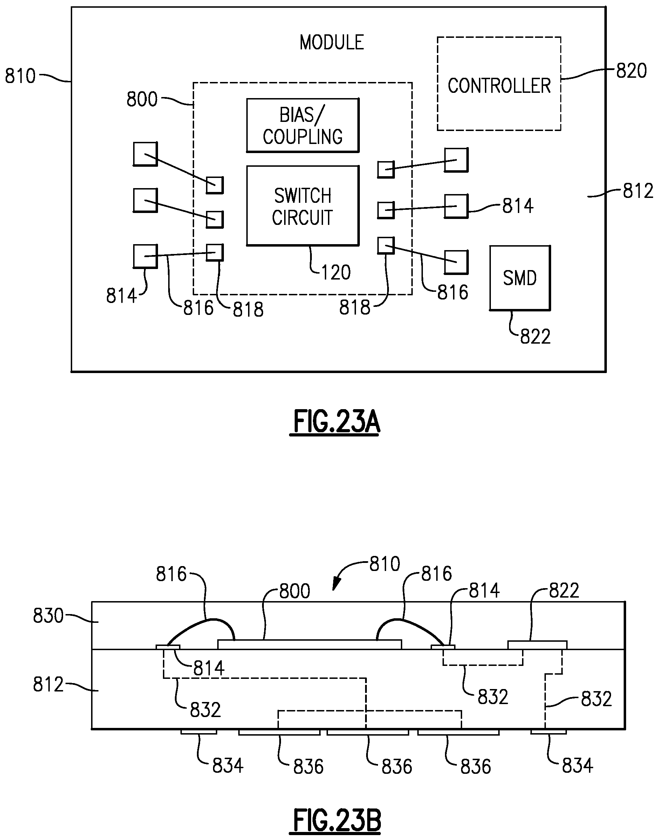

In some embodiments, one or more die having one or more features described herein can be implemented in a packaged module. An example of such a module is shown in Figures 23A (plan view) and 23B (side view). Although described in the context of both of the switch circuit and the bias/coupling circuit being on the same die (e.g., example configuration of Figure 22A), it will be understood that packaged modules can be based on other configurations.

A module 810 is shown to include a packaging substrate 812. Such a packaging substrate can be configured to receive a plurality of components, and can include, for example, a laminate substrate. The components mounted on the packaging substrate 812 can include one or more dies. In the example shown, a die 800 having a switching circuit 120 and a bias/coupling circuit 150 is shown to be mounted on the packaging substrate 812. The die 800 can be electrically connected to other parts of the module (and with each other where more than one die is utilized) through connections such as connection-wirebonds 816. Such connection-wirebonds can be formed between contact pads 818 formed on the die 800 and contact pads 814 formed on the packaging substrate 812. In some embodiments, one or more surface mounted devices (SMDs) 822 can be mounted on the packaging substrate 812 to facilitate various functionalities of the module 810.

In some embodiments, the packaging substrate 812 can include electrical connection paths for interconnecting the various components with each other and/or with contact pads for external connections. For example, a connection path 832 is depicted as interconnecting the example SMD 822 and the die 800. In another example, a connection path 832 is depicted as interconnecting the SMD 822 with an external-connection contact pad 834. In yet another example a connection path 832 is depicted as interconnecting the die 800 with ground-connection contact pads 836.

In some embodiments, a space above the packaging substrate 812 and the various components mounted thereon can be filled with an overmold structure 830. Such an overmold structure can provide a number of desirable functionalities, including protection for the components and wirebonds from external elements, and easier handling of the packaged module 810.

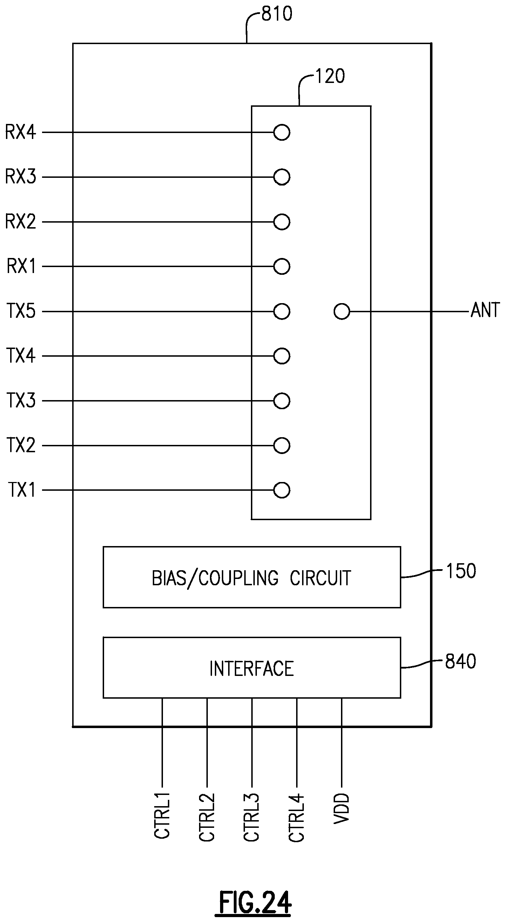

Figure 24 shows a schematic diagram of an example switching configuration that can be implemented in the module 810 described in reference to Figures 23A and 23B. In the example, the switch circuit 120 is depicted as being an SP9T switch, with the pole being connectable to an antenna and the throws being connectable to various Rx and Tx paths. Such a configuration can facilitate, for example, multi-mode multi-band operations in wireless devices.

The module 810 can further include an interface for receiving power (e.g., supply voltage VDD) and control signals to facilitate operation of the switch circuit 120 and/or the bias/coupling circuit 150. In some implementations, supply voltage and control signals can be applied to the switch circuit 120 via the bias/coupling circuit 150.

### Wireless Device Implementation

In some implementations, a device and/or a circuit having one or more features described herein can be included in an RF device such as a wireless device. Such a device and/or a circuit can be implemented directly in the wireless device, in a modular form as described herein, or in some combination thereof. In some embodiments, such a wireless device can include, for example, a cellular phone, a smart-phone, a hand-held wireless device with or without phone functionality, a wireless tablet, etc.

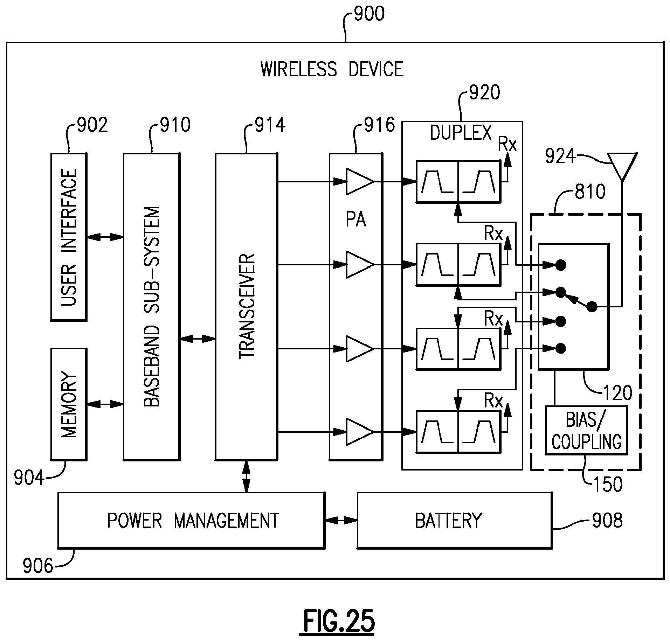

Figure 25 schematically depicts an example wireless device 900 having one or more advantageous features described herein. In the context of various switches and various biasing/coupling configurations as described herein, a switch 120 and a bias/coupling circuit 150 can be part of a module 810. In some embodiments, such a switch module can facilitate, for example, multi-band multi-mode operation of the wireless device 900.

In the example wireless device 900, a power amplifier (PA) module 916 having a plurality of PAs can provide an amplified RF signal to the switch 120 (via a duplexer 920), and the switch 120 can route the amplified RF signal to an antenna. The PA module 916 can receive an unamplified RF signal from a transceiver 914 that can be configured and operated in known manners. The transceiver can also be configured to process received signals. The transceiver 914 is shown to interact with a baseband sub-system 910 that is configured to provide conversion between data and/or voice signals suitable for a user and RF signals suitable for the transceiver 914. The transceiver 914 is also shown to be connected to a power management component 906 that is configured to manage power for the operation of the wireless device 900. Such a power management component can also control operations of the baseband sub-system 910 and the module 810.

The baseband sub-system 910 is shown to be connected to a user interface 902 to facilitate various input and output of voice and/or data provided to and received from the user. The baseband sub-system 910 can also be connected to a memory 904 that is configured to store data and/or instructions to facilitate the operation of the wireless device, and/or to provide storage of information for the user.

In some embodiments, the duplexer 920 can allow transmit and receive operations to be performed simultaneously using a common antenna (e.g., 924). In Figure 25, received signals are shown to be routed to "Rx" paths (not shown) that can include, for example, a low-noise amplifier (LNA).

A number of other wireless device configurations can utilize one or more features described herein. For example, a wireless device does not need to be a multi-band device. In another example, a wireless device can include additional antennas such as diversity antenna, and additional connectivity features such as Wi-Fi, Bluetooth, and GPS.

## Claims

1. A switching device (100) comprising:
a first terminal (202) and a second terminal (204);
a plurality of field-effect transistors, FETs (30), implemented in a stack configuration (20) between the first terminal and the second terminal, each FET having a source, a drain and a gate, the FETs configured to be in an ON state or an OFF state to respectively allow or inhibit passage of a radio-frequency, RF, signal between the first and second terminals; and
a bias circuit (200) having a bias input node (230) and a gate resistance network that couples the bias input node to the gate of each FET, the gate resistance network including a plurality of first nodes (212-218) and one or more second nodes (222), each first node of the plurality of first nodes (212-218) connected to more than one of the gates through respective first resistive paths (Rg1-Rg8), each second node (222) of the one or more second nodes (222) connected to one or more first nodes of the plurality of first nodes (212-218) through one or more respective second resistive paths (RM1-RM4), the gate of each FET being coupled to the bias input node through a first node of the plurality of first nodes and a second node of the one or more second nodes.

2. The switching device of claim 1 wherein the bias input node is connected to the one or more second nodes through a common resistance.

3. The switching device of claim 2 wherein the one or more second nodes are connected to a plurality of first nodes through their respective inter-node resistances.

4. The switching device of claim 1 wherein the FETs are silicon-on-insulator FETs.

5. The switching device of claim 4 wherein each FET of the plurality of FETs is implemented as a finger configuration device such that the gate includes a number of rectangular shaped gate fingers, each gate finger implemented between a rectangular shaped source finger of the source contact and a rectangular shaped drain finger of the drain contact.

6. The switching circuit of claim 1 wherein the first terminal is an input terminal and the second terminal is an output terminal for the RF signal.

7. The switching device of claim 1 further comprising a source/drain bias circuit having a source/drain bias input node and a distribution network that couples the source/drain bias input node to the source/drain of each FET, the distribution network including a plurality of first nodes, each first node of the distribution network connected to one or more of the sources/drains through one or more respective first resistive paths, the distribution network further including one or more second nodes, each second node of the source/drain-biasing distribution network connected to one or more of the first nodes of the source/drain-biasing distribution network through one or more respective second resistive paths, the source/drain of each FET being coupled to the source/drain bias input node through a first node of the plurality of first nodes and a second node of the one or more second nodes.

8. The switching device of claim 1 further comprising a body bias circuit having a body bias input node and a distribution network that couples the body bias input node to the body of each FET, the distribution network including a plurality of first nodes, each first node of the distribution network connected to one or more of the bodies through one or more respective first resistive paths, the distribution network further including one or more second nodes, each second node of the body-biasing distribution network connected to one or more of the first nodes of the body-biasing distribution network through one or more respective second resistive paths, each first node of the plurality of first nodes connected to a single second node of the one or more second nodes through one of said one or more respective second resistive paths, the body of each FET being coupled to the body bias input node through a first node of the plurality of first nodes and a second node of the one or more second nodes.

9. The switching device of claim 1 wherein the gate resistance network of the bias circuit includes a plurality of second nodes.

10. A semiconductor die (800) comprising:
a semiconductor substrate; and
the switching device of any of claims 1 to 9 implemented on the semiconductor substrate.

11. A method for fabricating a radio-frequency, RF, switching device, the method comprising:
providing a semiconductor substrate;
forming a switching circuit on the semiconductor substrate, the switching circuit including a plurality of field-effect transistors (30), FETs, implemented in a stack configuration between the first (202) and a second terminal (204), each FET having a source, a drain and a gate, the FETs configured to be in an ON state or an OFF state to respectively allow or inhibit passage of an RF signal through the stack; and
forming a bias circuit (200) on the semiconductor substrate, the bias circuit having a bias input node (230) and a gate resistance network that couples the bias input node to the gate of each FET, the gate resistance network including a plurality of first nodes (212-218) and one or more second nodes (222), each first node of the plurality of first nodes (212-218) connected to one or more of the gates through one or more respective first resistive paths, each second node of the one or more second nodes (222) connected to one or more first nodes of the plurality of first nodes (212-218) through one or more respective second resistive paths (RM1-RM4), the gate of each FET being coupled to the bias input node through a first node of the plurality of first nodes and a second node of the one or more second nodes.

12. A radio-frequency, RF, switching module (810) comprising:
a packaging substrate (812) configured to receive a plurality of components; and
a die (800) mounted on the packaging substrate, the die having a switching device according to any of claims 1 to 9.

13. A wireless device (900) comprising:
a transmitter (914);
a power amplifier in communication with the transmitter, the power amplifier configured to amplify a radio-frequency, RF, signal generated by the transmitter;
an antenna configured to transmit the amplified RF signal; and
a switching device according to any of claims 1 to 9, the switching circuit configured to route the amplified RF signal from the power amplifier to the antenna.

## Patentansprüche

1. Schaltvorrichtung (100), die Folgendes umfasst:
einen ersten Anschluss (202) und einen zweiten Anschluss (204) ;
eine Mehrzahl von Feldeffekttransistoren, FETs (30), die in einer Stapelkonfiguration (20) zwischen dem ersten Anschluss und dem zweiten Anschluss implementiert sind, wobei jeder FET eine Source, einen Drain und ein Gate aufweist, wobei die FETs so konfiguriert sind, dass sie in einem EIN-Zustand oder einem AUS-Zustand sind, um jeweils die Passage eines Hochfrequenz-(HF)-Signals zwischen dem ersten und dem zweiten Anschluss zuzulassen oder zu verhindern; und
eine Vorspannungsschaltung (200) mit einem Vorspannungseingangsknoten (230) und einem Gate-Widerstandsnetzwerk, das den Vorspannungseingangsknoten mit dem Gate jedes FET koppelt, wobei das Gate-Widerstandsnetzwerk eine Mehrzahl von ersten Knoten (212-218) und einen oder mehrere zweite Knoten (222) enthält, wobei jeder erste Knoten aus der Mehrzahl von ersten Knoten (212-218) mit mehr als einem der Gates über jeweilige erste Widerstandspfade (Rg1-Rg8) verbunden ist, wobei jeder zweite Knoten (222) der ein oder mehreren zweiten Knoten (222) mit einem oder mehreren ersten Knoten aus der Mehrzahl von ersten Knoten (212-218) über einen oder mehrere jeweilige zweite Widerstandspfade (RM1-RM4) verbunden ist, wobei das Gate jedes FET mit dem Vorspannungseingangsknoten über einen ersten Knoten aus der Mehrzahl von ersten Knoten und einen zweiten Knoten der ein oder mehreren zweiten Knoten gekoppelt ist.

2. Schaltvorrichtung nach Anspruch 1, wobei der Vorspannungseingangsknoten mit den ein oder mehreren zweiten Knoten über einen gemeinsamen Widerstand verbunden ist.

3. Schaltvorrichtung nach Anspruch 2, wobei die ein oder mehreren zweiten Knoten über ihre jeweiligen Zwischenknotenwiderstände mit einer Mehrzahl von ersten Knoten verbunden sind.

4. Schaltvorrichtung nach Anspruch 1, wobei die FETs Silicium-auf-Isolator-FETs sind.

5. Schaltvorrichtung nach Anspruch 4, wobei jeder FET aus der Mehrzahl von FETs als Fingerkonfigurationsbauelement implementiert ist, so dass das Gate eine Anzahl von rechteckig geformten Gate-Fingern enthält, wobei jeder Gate-Finger zwischen einem rechteckig geformten Source-Finger des Source-Kontakts und einem rechteckig geformten Drain-Finger des Drain-Kontakts implementiert ist.

6. Schaltvorrichtung nach Anspruch 1, wobei der erste Anschluss ein Eingangsanschluss und der zweite Anschluss ein Ausgangsanschluss für das HF-Signal ist.

7. Schaltvorrichtung nach Anspruch 1, das ferner eine Source/Drain-Vorspannungsschaltung mit einem Source/Drain-Vorspannungseingangsknoten und einem Verteilungsnetzwerk umfasst, das den Source/Drain-Vorspannungseingangsknoten mit der/dem Source/Drain jedes FET koppelt, wobei das Verteilungsnetzwerk mehrere erste Knoten umfasst, wobei jeder erste Knoten des Verteilungsnetzwerks mit einer/m oder mehreren der Sources/Drains über einen oder mehrere jeweilige erste Widerstandspfade verbunden ist, wobei das Verteilungsnetzwerk ferner einen oder mehrere zweite Knoten enthält, wobei jeder zweite Knoten des Source/Drain-Vorspannungsverteilernetzes mit einem oder mehreren der ersten Knoten des Source/Drain-Vorspannungs-Verteilungsnetzwerks über einen oder mehrere jeweilige zweite Widerstandspfade verbunden ist, wobei die/der Source/Drain jedes FET mit dem Source/Drain-Vorspannungseingangsknoten über einen ersten Knoten aus der Mehrzahl von ersten Knoten und einen zweiten Knoten der ein oder mehreren zweiten Knoten gekoppelt ist.

8. Schaltvorrichtung nach Anspruch 1, das ferner eine Körpervorspannungsschaltung mit einem Körpervorspannungseingangsknoten und einem Verteilungsnetzwerk umfasst, das den Körpervorspannungseingangsknoten mit dem Körper jedes FET koppelt, wobei das Verteilungsnetzwerk eine Mehrzahl von ersten Knoten umfasst, wobei jeder erste Knoten des Verteilungsnetzwerks mit einem oder mehreren der Körper über einen oder mehrere jeweilige erste Widerstandspfade verbunden ist, wobei das Verteilungsnetzwerk ferner einen oder mehrere zweite Knoten umfasst, wobei jeder zweite Knoten des Körpervorspannungs-Verteilungsnetzwerks mit einem oder mehreren der ersten Knoten des Körpervorspannungs-Verteilungsnetzwerks über einen oder mehrere jeweilige zweite Widerstandspfade verbunden ist, wobei jeder erste Knoten aus der Mehrzahl von ersten Knoten mit einem einzelnen zweiten Knoten der ein oder mehreren zweiten Knoten über einen der genannten ein oder mehreren jeweiligen zweiten Widerstandspfade verbunden ist, wobei der Körper jedes FET mit dem Körpervorspannungseingangsknoten über einen ersten Knoten aus der Mehrzahl von ersten Knoten und einen zweiten Knoten der ein oder mehreren zweiten Knoten gekoppelt ist.

9. Schaltvorrichtung nach Anspruch 1, wobei das Gate-Widerstandsnetzwerk der Vorspannungsschaltung eine Mehrzahl von zweiten Knoten enthält.

10. Halbleiterchip (800), der Folgendes umfasst:
ein Halbleitersubstrat; und
die Schaltvorrichtung nach einem der Ansprüche 1 bis 9 auf dem Halbleitersubstrat implementiert.

11. Verfahren zum Herstellen einer Hochfrequenz-(HF)-Schaltvorrichtung, wobei das Verfahren Folgendes beinhaltet:
Bereitstellen eines Halbleitersubstrats;
Bilden einer Umschaltschaltung auf dem Halbleitersubstrat, wobei die Umschaltschaltung eine Mehrzahl von Feldeffekttransistoren FETs (30) enthält, die in einer Stapelkonfiguration zwischen dem ersten (202) und einem zweiten (204) Anschluss implementiert sind, wobei jeder FET eine Source, einen Drain und ein Gate aufweist, wobei die FETs so konfiguriert sind, dass sie in einem EIN-Zustand oder einem AUS-Zustand sind, um die Passage eines HF-Signals durch den Stapel zuzulassen bzw. zu verhindern; und
Bilden einer Vorspannungsschaltung (200) auf dem Halbleitersubstrat, wobei die Vorspannungsschaltung einen Vorspannungseingangsknoten (230) und ein Gate-Widerstandsnetzwerk aufweist, das den Vorspannungseingangsknoten mit dem Gate jedes FET koppelt, wobei das Gate-Widerstandsnetzwerk eine Mehrzahl von ersten Knoten (212-218) und einen oder mehrere zweite Knoten (222) enthält, wobei jeder erste Knoten aus der Mehrzahl von ersten Knoten (212-218) mit einem oder mehreren der Gates über einen oder mehrere jeweilige erste Widerstandspfade verbunden ist, wobei jeder zweite Knoten der ein oder mehreren zweiten Knoten (222) mit einem oder mehreren ersten Knoten aus der Mehrzahl von ersten Knoten (212-218) über einen oder mehrere jeweilige zweite Widerstandspfade (RM1-RM4) verbunden ist, wobei das Gate jedes FET mit dem Vorspannungseingangsknoten über einen ersten Knoten aus der Mehrzahl von ersten Knoten und einen zweiten Knoten der ein oder mehreren zweiten Knoten gekoppelt ist.

12. Hochfrequenz-(HF)-Schaltmodul (810), das Folgendes umfasst:
ein Gehäusesubstrat (812), konfiguriert zum Aufnehmen einer Mehrzahl von Komponenten; und
einen auf dem Gehäusesubstrat montierten Chip (800), wobei der Chip eine Schaltvorrichtung nach einem der Ansprüche 1 bis 9 aufweist.

13. Drahtlose Vorrichtung (900), die Folgendes umfasst:
einen Sender (914);
einen Leistungsverstärker, der mit dem Sender in Verbindung steht, wobei der Leistungsverstärker zum Verstärken eines vom Sender erzeugten Hochfrequenz-(HF)-Signals konfiguriert ist;
eine Antenne, die zum Senden des verstärkten HF-Signals konfiguriert ist; und
eine Schaltvorrichtung nach einem der Ansprüche 1 bis 9, wobei die Umschaltschaltung zum Leiten des verstärkten HF-Signals vom Leistungsverstärker zur Antenne konfiguriert ist.

## Revendications

1. Dispositif de commutation (100) comprenant :
une première borne (202) et une deuxième borne (204) ;
une pluralité de transistors à effet de champ, TEC (30), mis en œuvre dans une configuration en pile (20) entre la première borne et la deuxième borne, chaque TEC ayant une source, un drain et une grille, les TEC étant configurés pour être dans un état PASSANT ou dans un état NON PASSANT pour permettre ou interdire respectivement le passage d'un signal radiofréquence, RF, entre la première et la deuxième borne ; et
un circuit de polarisation (200) ayant un nœud d'entrée de polarisation (230) et un réseau de résistance de grille qui couple le nœud d'entrée de polarisation à la grille de chaque TEC, le réseau de résistance de grille comprenant une pluralité de premier nœuds (212-218) et un ou plusieurs deuxièmes nœuds (222), chaque premier nœud de la pluralité de premiers nœuds (212-218) étant connecté à plus de l'une des grilles par des premiers chemins résistifs respectifs (Rg1-Rg8), chaque deuxième nœud (222) de l'un ou plusieurs deuxièmes nœuds (222) étant connecté à un ou plusieurs premiers nœuds de la pluralité de premiers nœuds (212-218) par un ou plusieurs deuxièmes chemins résistifs respectifs (RM1-RM4), la grille de chaque TEC étant couplée au nœud d'entrée de polarisation par un premier nœud de la pluralité de premiers nœuds et un deuxième nœud de l'un ou plusieurs deuxièmes nœuds.

2. Dispositif de commutation selon la revendication 1, dans lequel le nœud d'entrée de polarisation est connecté à l'un ou plusieurs deuxièmes nœuds par une résistance commune.

3. Dispositif de commutation selon la revendication 2, dans lequel l'un ou plusieurs deuxièmes nœuds sont connectés à une pluralité de premiers nœuds par leurs résistances inter-nœuds respectives.

4. Dispositif de commutation selon la revendication 1, dans lequel les TEC sont des TEC au silicium sur isolant.

5. Dispositif de commutation selon la revendication 1, dans lequel chaque TEC de la pluralité de TEC est mis en œuvre comme un dispositif à configuration de doigts de telle sorte que la grille comprend un nombre de doigts de grille de forme rectangulaire, chaque doigt de grille étant mis en œuvre entre un doigt de source de forme rectangulaire du contact de source et un doigt de drain de forme rectangulaire du contact de drain.

6. Circuit de commutation selon la revendication 1, dans lequel la première borne est une borne d'entrée et la deuxième borne est une borne de sortie pour le signal RF.

7. Dispositif de commutation selon la revendication 1, comprenant en outre un circuit de polarisation de source/drain ayant un nœud d'entrée de polarisation de source/drain et un réseau de distribution qui couple le nœud d'entrée de polarisation de source/drain à la source/drain de chaque TEC, le réseau de distribution comprenant une pluralité de premiers nœuds, chaque premier nœud du réseau de distribution étant connecté à une ou plusieurs des sources/drains par un ou plusieurs premiers chemins résistifs respectifs, le réseau de distribution comprenant en outre un ou plusieurs deuxièmes nœuds, chaque deuxième nœud du réseau de distribution de polarisation source/drain étant connecté à un ou plusieurs des premiers nœuds du réseau de distribution de polarisation source/drain par un ou plusieurs deuxièmes chemins résistifs respectifs, la source/drain de chaque TEC étant couplé au nœud d'entrée de polarisation de source/drain par un premier nœud de la pluralité de premiers nœuds et un deuxième nœud de l'un ou plusieurs deuxième nœuds.

8. Dispositif de commutation selon la revendication 1, comprenant en outre un circuit de polarisation de corps ayant un nœud d'entrée de polarisation de corps et un réseau de distribution qui couple le nœud d'entrée de polarisation de corps au corps de chaque TEC, le réseau de distribution comprenant une pluralité de premiers nœuds, chaque premier nœud du réseau de distribution étant connecté à un ou plusieurs des corps par un ou plusieurs premiers chemins résistifs respectifs, le réseau de distribution comprenant en outre un ou plusieurs deuxièmes nœuds, chaque deuxième nœud du réseau de distribution de polarisation de corps étant connecté à un ou plusieurs des premiers nœuds du réseau de distribution de polarisation de corps par un ou plusieurs deuxièmes chemins résistifs respectifs, chaque premier nœud de la pluralité de premiers nœuds étant connecté à un seul deuxième nœud de l'un ou plusieurs deuxièmes nœuds par un dudit un ou desdits plusieurs deuxièmes chemins résistifs respectifs, le corps de chaque TEC étant couplé au nœud d'entrée de polarisation de corps par un premier nœud de la pluralité de premiers nœuds et un deuxième nœud de l'un ou plusieurs deuxièmes nœuds.

9. Dispositif de commutation selon la revendication 1, dans lequel le réseau de résistance de grille du circuit de polarisation comprend une pluralité de deuxièmes nœuds.

10. Dé de semiconducteur (800) comprenant :
un substrat semiconducteur ; et
le dispositif de commutation selon l'une quelconque des revendications 1 à 9 mis en œuvre sur le substrat semiconducteur.

11. Procédé de fabrication d'un dispositif de commutation radiofréquence, FR, le procédé comprenant :
fournir un substrat semiconducteur ;
former un circuit de commutation sur le substrat semiconducteur, le circuit de commutation comprenant une pluralité de transistors à effet de champ (30), TEC, mis en œuvre dans une configuration en pile entre la première (202) et une deuxième borne (204),
chaque TEC ayant une source, un drain et une grille, les TEC étant configurés pour être dans un état PASSANT ou dans un état NON PASSANT pour permettre ou interdire respectivement le passage d'un signal RF à travers la pile ; et
former un circuit de polarisation (200) sur le substrat semiconducteur, le circuit de polarisation ayant un nœud d'entrée de polarisation (230) et un réseau de résistance de grille qui couple le nœud d'entrée de polarisation à la grille de chaque TEC, le réseau de résistance de grille comprenant une pluralité de premiers nœuds (212-218) et un ou plusieurs deuxièmes nœuds (222), chaque premier nœud de la pluralité de premiers nœuds (212-218) étant connecté à une ou plusieurs des grilles par un ou plusieurs premiers chemins résistifs respectifs, chaque deuxième nœud de l'un ou plusieurs deuxièmes nœuds (222) étant connecté à un ou plusieurs premiers nœuds de la pluralité de premiers nœuds (212-218) par un ou plusieurs deuxièmes chemins résistifs respectifs (RM1-RM4),
la grille de chaque TEC étant couplée au nœud d'entrée de polarisation par un premier nœud de la pluralité de premiers nœuds et un deuxième nœud de l'un ou plusieurs deuxièmes nœuds.

12. Module de commutation radiofréquence, RF, (810) comprenant :
un substrat d'encapsulation (812) configuré pour recevoir une pluralité de composants ; et
un dé (800) monté sur le substrat d'encapsulation, le dé ayant un dispositif de commutation selon l'une quelconque des revendications 1 à 9.

13. Dispositif sans fil (900) comprenant :
un transmetteur (914) ;
un amplificateur de puissance en communication avec le transmetteur, l'amplificateur de puissance étant configuré pour amplifier un signal radiofréquence, RF, généré par le transmetteur ;
une antenne configurée pour transmettre le signal RF amplifié ; et
un dispositif de commutation selon l'une quelconque des revendications 1 à 9, le circuit de commutation étant configuré pour acheminer le signal RF amplifié de l'amplificateur de puissance à l'antenne.
